# EUROPEAN PATENT APPLICATION

(11) **EP 4 102 535 A1**
(43) Date of publication of application: **14.12.2022**
(21) Application number: 21178234.7
(22) Date of filing: 08.06.2021
(51) Int. Cl.: H01J 37/073

(54) **CHARGED PARTICLE APPARATUS AND METHOD**

(71) Applicant: ASML Netherlands B.V., 5500 AH Veldhoven (NL)
(72) Inventor: VAN SOEST, Jurgen, 5500 AH Veldhoven (NL); VEENSTRA, Roy Ramon, 5500 AH Veldhoven (NL); SMAKMAN, Erwin Paul, 5500 AH Veldhoven (NL); VAN ZUTPHEN, Tom, 5626 DS Eindhoven (NL); MANGNUS, Albertus Victor Gerardus, 5500 AH Veldhoven (NL)
(74) Representative: ASML Netherlands B.V.

(57) **Abstract**

The disclosure relates to a charged particle beam apparatus configured to project charged particle beams towards a sample. The charged particle beam apparatus comprises: a plurality of charged particle-optical columns configured to project respective charged particle beams towards the sample, wherein each charged particle-optical column comprises: a charged particle source configured to emit the charged particle beam towards the sample, the charged particle sources being comprised in a source array; an objective lens comprising an electrostatic electrode configured to direct the charged particle beam towards the sample; and a detector associated with the objective lens array, configured to detect signal charged particles emitted from the sample. The objective lens is the most down-beam element of the charged particle-optical column configured to affect the charged particle beam directed towards the sample.

## Description

### FIELD

The embodiments provided herein relate generally to charged particle beam apparatuses and methods of using a charged particle beam apparatus.

### BACKGROUND

When manufacturing semiconductor integrated circuit (IC) chips, undesired pattern defects, as a consequence of, for example, optical effects and incidental particles, inevitably occur on a substrate (i.e. wafer) or a mask during the fabrication processes, thereby reducing the yield. Monitoring the extent of the undesired pattern defects is therefore an important process in the manufacture of IC chips. More generally, the inspection and/or measurement of a surface of a substrate, or other object/material, is an important process during and/or after its manufacture.

Pattern inspection tools with a charged particle beam have been used to inspect objects, for example to detect pattern defects. These tools typically use electron microscopy techniques, such as a scanning electron microscope (SEM). In an SEM, a primary electron beam of electrons at a relatively high energy is targeted with a final deceleration step in order to land on a sample at a relatively low landing energy. The beam of electrons is focused as a probing spot on the sample. The interactions between the material structure at the probing spot and the landing electrons from the beam of electrons cause electrons to be emitted from the surface, such as secondary electrons, backscattered electrons or Auger electrons. The generated secondary electrons may be emitted from the material structure of the sample. By scanning the primary electron beam as the probing spot over the sample surface, secondary electrons can be emitted across the surface of the sample. By collecting these emitted secondary electrons from the sample surface it is possible to obtain an image representing characteristics of the material structure of the surface of the sample.

Pattern inspection tools are provided with a source of the beam of electrons. Such a source features an emitter which emits the electron beam. There is a general need to improve the combination of reduced brightness, total current and current stability of the source of the beam of electrons.

### SUMMARY

It is an object of the invention to improve the combination of reduced brightness, total current and current stability of the beam of electrons.

According to an aspect of the invention, there is provided a charged particle beam apparatus configured to project charged particle beams towards a sample, wherein the charged particle beam apparatus comprises: a plurality of charged particle-optical columns configured to project respective charged particle beams towards the sample, wherein each charged particle-optical column comprises: a charged particle emitter configured to emit the charged particle beam towards the sample, the charged particle emitters being comprised in a source array; an objective lens comprising an electrostatic electrode configured to direct the charged particle beam towards the sample, the objective lenses being comprised in an objective lens array, the electrostatic electrode being common to a plurality of the charged particle-optical columns; and a detector associated with the objective lens array, configured to detect signal charged particles emitted from the sample, wherein the objective lens is the most down-beam element of the charged particle-optical column configured to affect the charged particle beam directed towards the sample.

According to an aspect of the invention, there is provided a charged particle beam apparatus configured to project charged particle beams towards a sample, wherein the charged particle beam apparatus comprises: a plurality of charged particle-optical columns configured to project respective charged particle beams towards the sample, wherein each charged particle-optical column comprises: a plurality of charged particle emitters configured to emit the charged particle beam towards the sample, the charged particle emitters being comprised in a source array; and preferably an objective lens configured to direct the charged particle beam towards the sample, the objective lenses being comprised in an objective lens array; wherein the charged particle emitters are configured to be selectable such that a subset of the charged particle emitters can be selected to emit the charged particle beams towards the sample.

According to an aspect of the invention, there is provided a charged particle beam apparatus configured to project charged particle beams towards a sample, wherein the charged particle beam apparatus comprises: a sample holder configured to hold the sample; a plurality of charged particle-optical columns configured to project respective charged particle beams towards the sample, wherein each charged particle-optical column comprises: a plurality of charged particle emitters configured to emit the charged particle beam towards the sample, the charged particle emitters being comprised in a source array; and preferably an objective lens configured to direct the charged particle beam towards the sample, the objective lenses being comprised in an objective lens array; wherein the charged particle beam apparatus is configured such that the sample holder and the charged particle-optical columns are movable relative to each other in a scanning direction, wherein the charged particle-optical columns are arranged in parallel lines at an oblique angle to the scanning direction.

According to an aspect of the invention, there is provided a charged particle beam apparatus configured to project charged particle beams towards a sample, wherein the charged particle beam apparatus comprises: a plurality of charged particle-optical columns configured to project respective charged particle beams towards the sample, wherein each charged particle-optical column comprises: a plurality of charged particle emitters configured to emit the charged particle beam towards the sample, the charged particle emitters being comprised in a source array; and preferably an objective lens configured to direct the charged particle beam towards the sample, the objective lenses being comprised in an objective lens array; wherein the charged particle emitters comprise at least one selected from a group consisting of silicon carbide, gallium nitride, aluminium nitride and boron nitride.

According to an aspect of the invention, there is provided a method of operating a charged particle beam apparatus comprising: a source array comprising charged particle emitters configured to emit a charged particle beam a plurality in an array of charged particle beams; and an array of charged particle-optical columns comprising a plurality of charged particle-optical columns configured to project respective charged particle beams from the source array towards a sample, wherein the method comprises: projecting the charged particle beams emitted by the charged particle emitters towards the sample; directing the charged particle beams towards the sample with respective objective lenses comprising an electrostatic electrode, the objective lenses being comprised in an objective lens array, by controlling electrostatic electrodes comprising the objective lens array by applying a potential to at least one of the electrodes that is common to a plurality of the charged particle-optical columns; and detect signal charged particles emitted from the sample with a detector associated with the objective lens array, wherein the objective lens is the most down-beam element of the charged particle-optical column configured to affect the charged particle beam directed towards the sample.

According to an aspect of the invention, there is provided a method of operating a charged particle beam apparatus comprising: a source array comprising charged particle emitters configured to emit a charged particle beam a plurality in an array of charged particle beams; and an array of charged particle-optical columns comprising a plurality of charged particle-optical columns configured to project respective charged particle beams from the source array towards a sample, wherein the method comprises: selecting a subset of charged particle emitters from the source array to emit the charged particle beams; and projecting the charged particle beams emitted by the subset of charged particle emitters towards the sample.

According to an aspect of the invention, there is provided a method of operating a charged particle beam apparatus comprising: a source array comprising: charged particle sources each configured to emit a charged particle beam, the source array configured to emit a plurality of the charged particle beams in an array of charged particle beams; and an array of charged particle-optical columns comprising a plurality of charged particle-optical columns configured to project respective charged particle beams from the source array towards a sample, wherein the method comprises: holding the sample with a sample holder; projecting the charged particle beams emitted by the charged particle sources towards the sample, preferably comprising using the charged particle-optical columns each projecting a single charged particle beam towards the sample; and moving the sample holder and the charged particle-optical columns relative to each other in a scanning direction; wherein the charged particle-optical columns are arranged in parallel lines at an oblique angle to the scanning direction.

According to an aspect of the invention, there is provided a method of operating a charged particle beam apparatus comprising: a source array comprising charged particle sources configured to emit a charged particle beam a plurality in an array of charged particle beams; and an array of charged particle-optical columns comprising a plurality of charged particle-optical columns configured to project respective charged particle beams from the source array towards a sample, wherein the method comprises: projecting the charged particle beams emitted by the charged particle sources towards the sample; wherein the charged particle sources comprise at least one selected from a group consisting of silicon carbide, gallium nitride, aluminium nitride and boron nitride.

According to an aspect of the invention, there is provided a charged particle beam apparatus configured to project charged particle beams towards a sample, wherein the charged particle beam apparatus comprises: a source array comprising a plurality of charged particle emitters configured to emit respective charged particle beams; and a charged particle-optical column array comprising a plurality of charged particle-optical columns configured to project a corresponding respective charged particle beam emitted by a charged particle emitter of the source array towards the sample, wherein each charged particle-optical column comprises: an objective lens and a detector, the objective lens comprising an electrostatic electrode configured to direct the charged particle beam towards the sample, the objective lenses being comprised in an objective lens array, the electrostatic electrode being common to a plurality of the charged particle-optical columns, the detector being associated with the objective lens array and configured to detect signal charged particles emitted from the sample; wherein the objective lens is the most down-beam element of the charged particle-optical column configured to affect the charged particle beam directed towards the sample.

According to an aspect of the invention, there is provided a charged particle beam apparatus configured to project charged particle beams towards a sample, wherein the charged particle beam apparatus comprises: a source array comprising a plurality of charged particle emitters configured to emit respective charged particle beams; a charged particle-optical column array comprising a plurality of charged particle-optical columns configured to project a corresponding respective charged particle beam emitted by a charged particle emitter of the source array towards the sample, wherein each charged particle-optical column optionally comprises: an objective lens configured to direct the charged particle beam towards the sample, the objective lenses being comprised in an objective lens array; wherein the charged particle emitters are configured to be selectable such that a subset of the charged particle emitters can be selected to emit the charged particle beams towards the substrate.

According to an aspect of the invention, there is provided a charged particle beam apparatus configured to project charged particle beams towards a sample, wherein the charged particle beam apparatus comprises: a sample holder configured to hold the sample; a source array comprising a plurality of charged particle sources configured to emit respective charged particle beams; and a charged particle-optical column array comprising a plurality of charged particle-optical columns configured to project a corresponding respective charged particle beam emitted by a charged particle source of the source array towards the sample, wherein the charged particle beam apparatus is configured such that the sample holder and the charged particle-optical columns are movable relative to each other in a scanning direction, wherein each charged particle-optical column optionally comprises: an objective lens configured to direct the charged particle beam towards the sample, the objective lenses being comprised in an objective lens array; wherein the charged particle-optical columns are arranged in a pattern in which parallel lines of charged particle-optical columns are at an oblique angle to the scanning direction.

According to an aspect of the invention, there is provided a charged particle beam apparatus configured to project charged particle beams towards a sample, wherein the charged particle beam apparatus comprises: a source array comprising a plurality of charged particle sources configured to emit respective charged particle beams; a charged particle-optical column array comprising a plurality of charged particle-optical columns configured to project a corresponding respective charged particle beam emitted by a charged particle source of the source array towards the sample, wherein each charged particle-optical column optionally comprises: an objective lens configured to direct the charged particle beam towards the sample, the objective lenses being comprised in an objective lens array; wherein the charged particle sources comprise at least one selected from a group consisting of silicon carbide, gallium nitride, aluminium nitride and boron nitride.

### BRIEF DESCRIPTION OF FIGURES

The above and other aspects of the present disclosure will become more apparent from the description of exemplary embodiments, taken in conjunction with the accompanying drawings.
Figure 1 is a schematic diagram illustrating an exemplary charged particle beam inspection apparatus.
Figure 2 is a schematic diagram illustrating an exemplary charged particle beam apparatus that is part of the exemplary charged particle beam inspection apparatus of Figure 1.
Figure 3 is a schematic diagram of a charged particle multi-beam column comprising a collimator array.
Figure 4 is a schematic diagram of a charged particle multi-beam column array comprising the multi-beam columns of Figure 3.
Figure 5 is a schematic plan view of a rectangular multi-beam column array.
Figure 6 is a schematic side sectional view of portions of electrodes forming decelerating objective lenses in a multi-beam column with a down-beam aperture array.
Figure 7 is a schematic magnified top sectional view relative to plane A-A in Figure 6 showing an aperture in the down-beam aperture array.
Figure 8 is a schematic side sectional view of an electron detection device integrated with a three-electrode objective lens array.
Figure 9 is a bottom view of a detector module of the type depicted in Figure 8 or 12.
Figure 10 depicts a part of a detector module in cross section.
Figure 11 is a schematic side sectional view of an electron detection device located in a down-beam surface of a sub-beam defining aperture array.
Figure 12 is an end view of the down-beam surface of the sub-beam defining aperture array of Figure 11.
Figure 13 is a schematic diagram illustrating a column array.
Figure 14 is a schematic diagram illustrating a column array.
Figure 15 is a schematic diagram illustrating a source of a source array of a column.
Figure 16 is a schematic diagram illustrating a pattern of columns of a column array.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

The enhanced computing power of electronic devices, which reduces the physical size of the devices, can be accomplished by significantly increasing the packing density of circuit components such as transistors, capacitors, diodes, etc. on an IC chip. This has been enabled by increased resolution enabling yet smaller structures to be made. For example, an IC chip of a smart phone, which is the size of a thumbnail and available in, or earlier than, 2019, may include over 2 billion transistors, the size of each transistor being less than 1/1000th of a human hair. Thus, it is not surprising that semiconductor IC manufacturing is a complex and time-consuming process, with hundreds of individual steps. Errors in even one step have the potential to dramatically affect the functioning of the final product. Just one "killer defect" can cause device failure. The goal of the manufacturing process is to improve the overall yield of the process. For example, to obtain a 75% yield for a 50-step process (where a step can indicate the number of layers formed on a wafer), each individual step must have a yield greater than 99.4%. If an individual step has a yield of 95%, the overall process yield would be as low as 7%.

While high process yield is desirable in an IC chip manufacturing facility, maintaining a high substrate (i.e. wafer) throughput, defined as the number of substrates processed per hour, is also essential. High process yield and high substrate throughput can be impacted by the presence of a defect. This is especially if operator intervention is required for reviewing the defects. Thus, high throughput detection and identification of micro-scale, nano-scale and sub-nano-scale defects by inspection tools (such as a Scanning Electron Microscope ('SEM')) is essential for maintaining high yield and low cost.

A SEM comprises a scanning device and a detector apparatus. The scanning device comprises an illumination apparatus that comprises an electron source, for generating primary electrons, and a projection apparatus for scanning a sample, such as a substrate, with one or more focused beams of primary electrons. Together at least the illumination apparatus, or illumination system, and the projection apparatus, or projection system, may be referred to together as the electron-optical system or apparatus. The primary electrons interact with the sample and generate signal electrons. The detection apparatus captures the signal electrons from the sample as the sample is scanned so that the SEM can create an image of the scanned area of the sample. For high throughput inspection, some of the inspection apparatuses use multiple focused beams, i.e. a multi-beam, of primary electrons. The component beams of the multi-beam may be referred to as sub-beams or beamlets. A multi-beam can scan different parts of a sample simultaneously. A multi-beam inspection apparatus can therefore inspect a sample at a much higher speed than a single-beam inspection apparatus.

The following figures are schematic. Relative dimensions of components in drawings are therefore exaggerated for clarity. Within the following description of drawings the same or like reference numbers refer to the same or like components or entities, and only the differences with respect to the individual embodiments are described. While the description and drawings are directed to an electron-optical apparatus, it is appreciated that the embodiments are not used to limit the present disclosure to specific charged particles. References to electrons throughout the present document may therefore be considered as general references to charged particles, with the charged particles not necessarily being electrons.

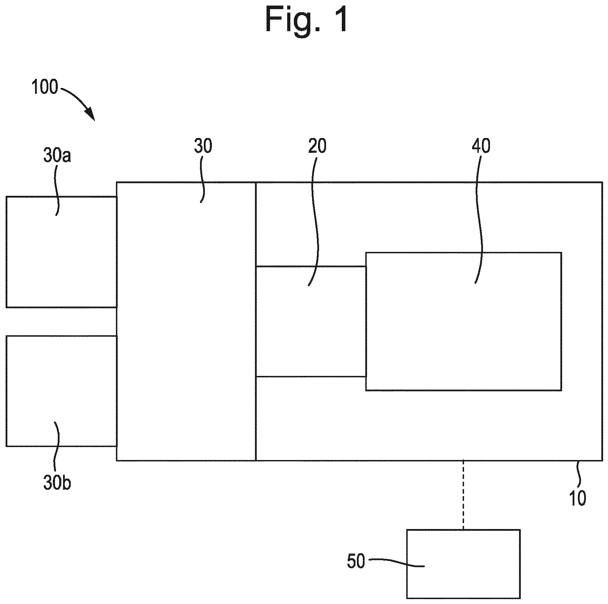

Reference is now made to Figure 1, which is a schematic diagram illustrating an exemplary electron beam inspection apparatus 100. The electron beam inspection apparatus 100 of Figure 1 includes a main chamber 10, a load lock chamber 20, an electron beam apparatus 40 (which may be referred to as an electron beam tool), an equipment front end module (EFEM) 30 and a controller 50. The electron beam apparatus 40 is located within main chamber 10.

The EFEM 30 includes a first loading port 30a and a second loading port 30b. The EFEM 30 may include additional loading port(s). The first loading port 30a and the second loading port 30b may, for example, receive substrate front opening unified pods (FOUPs) that contain substrates (e.g., semiconductor substrates or substrates made of other material(s)) or samples to be inspected (substrates, wafers and samples are collectively referred to as "samples" hereafter). One or more robot arms (not shown) in the EFEM 30 transport the samples to the load lock chamber 20.

The load lock chamber 20 is used to remove the gas around a sample. This creates a vacuum that is a local gas pressure lower than the pressure in the surrounding environment. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. After reaching the first pressure, one or more robot arms (not shown) transport the sample from the load lock chamber 20 to the main chamber 10. The main chamber 10 is connected to a main chamber vacuum pump system (not shown). The main chamber vacuum pump system removes gas particles in the main chamber 10 so that the pressure around the sample reaches a second pressure lower than the first pressure. After reaching the second pressure, the sample is transported to the electron beam apparatus 40 by which it may be inspected. An electron beam apparatus 40 may be a multi-beam apparatus.

The controller 50 is electronically connected to electron beam apparatus 40. Controller 50 may be a processor (such as a computer) configured to control the charged particle beam inspection apparatus 100. Controller 50 may also include a processing circuitry configured to execute various signal and image processing functions. While controller 50 is shown in Figure 1 as being outside of the structure that includes main chamber 10, load lock chamber 20, and EFEM 30, it is appreciated that controller 50 may be part of the structure. The controller 50 may be located in one of the component elements of the charged particle beam inspection apparatus 100 or it can be distributed over at least two of the component elements.

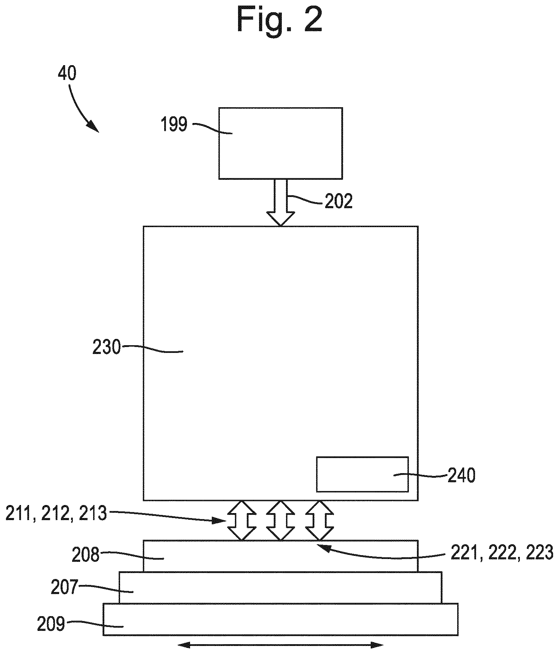

Reference is now made to Figure 2, which is a schematic diagram illustrating an exemplary electron beam apparatus 40 that is part of the exemplary charged particle beam inspection apparatus 100 of Figure 1. The electron beam apparatus 40 may comprise electron sources199, a projection apparatus 230, a motorized stage 209, and a sample holder 207. In an embodiment a plurality of electron sources 199 are provided. The electron sources 199 and the projection apparatus 230 may together be referred to as an electron-optical apparatus. The sample holder 207 is supported by motorized stage 209 so as to hold a sample 208 (e.g., a substrate or a mask) for inspection. The electron beam apparatus 40 may further comprise an electron detection device 240.

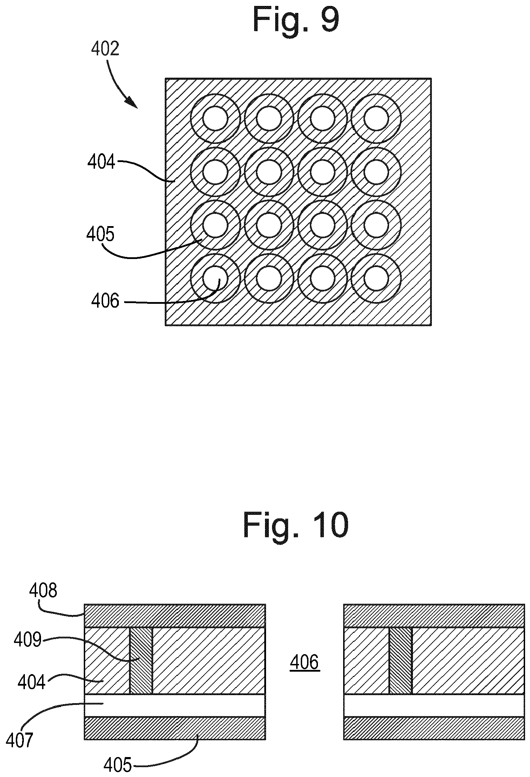

The electron source 199 may comprise a cathode (not shown) and an extractor or anode (shown in Figure 9). The electron sources 199 may be configured to emit electrons as primary electrons from the cathode. The primary electrons are extracted or accelerated by the extractor and/or the anode to form electron beams 202 comprising primary electrons.

The projection apparatus 230 may be configured to convert the electron beams 202 into a plurality of beamlets 211, 212, 213 and to direct each beamlet onto the sample 208. Although three beamlets are illustrated for simplicity, there may be many tens, many hundreds or many thousands of beamlets.

The controller 50 may be connected to various parts of the electron beam inspection apparatus 100 of Figure 1, such as the electron source 199, the electron detection device 240, the projection apparatus 230, and the motorized stage 209. The controller 50 may perform various image and signal processing functions. The controller 50 may also generate various control signals to govern operations of the electron beam inspection apparatus 100, including the electron beam apparatus 40.

The projection apparatus 230 may be configured to focus the beamlets 211, 212, and 213 onto a sample 208 for inspection and may form three probe spots 221, 222, and 223 on the surface of sample 208. The projection apparatus 230 may be configured to deflect the beamlets 211, 212, and 213 to scan the probe spots 221, 222, and 223 across individual scanning areas in a section of the surface of sample 208. Such scanning may comprise an electrostatic operation achieved by electrostatic deflectors in the electron-optical column, and movement of the stage so that a sample surface is moved under the probe spot so that the spot scans the sample surface. In response to incidence of the beamlets 211, 212, and 213 on the probe spots 221, 222, and 223 on the sample 208, electrons may be generated from the sample 208 which may include signal particles such as secondary electrons and backscattered electrons. The secondary electrons typically have electron energy ≤ 50 eV. The backscattered electrons typically have electron energy between 50 eV and the landing energy of the beamlets 211, 212, and 213.

The electron detection device 240 may be configured to detect signal electrons and to generate corresponding signals which are sent to the controller 50 or a signal processing system (not shown), e.g. to construct images of the corresponding scanned areas of the sample 208. The electron detection device 240 may be incorporated into the projection apparatus 230 or may be separate therefrom, with a secondary optical column being provided to direct signal electrons to the electron detection device 240.

The controller 50 may comprise an image processing system that includes an image acquirer (not shown) and a storage device (not shown). For example, the controller 50 may comprise a processor, computer, server, mainframe host, terminals, personal computer, any kind of mobile computing devices, and the like, or a combination thereof. The image acquirer may comprise at least part of the processing function of the controller. Thus the image acquirer may comprise at least one or more processors. The image acquirer may be communicatively coupled to an electron detection device 240 of the electron beam apparatus 40 permitting signal communication, such as an electrical conductor, optical fiber cable, portable storage media, IR, Bluetooth, internet, wireless network, wireless radio, among others, or a combination thereof. The image acquirer may receive a signal from the electron detection device 240, may process the data comprised in the signal and may construct an image therefrom. The image acquirer may thus acquire images of the sample 208. The image acquirer may also perform various post-processing functions, such as generating contours, superimposing indicators on an acquired image, and the like. The image acquirer may be configured to perform adjustments of brightness and contrast, etc. of acquired images. The storage may be a storage medium such as a hard disk, flash drive, cloud storage, random access memory (RAM), other types of computer readable memory, and the like. The storage may be coupled with the image acquirer and may be used for saving scanned raw image data as original images, and post-processed images.

The image acquirer may acquire one or more images of a sample based on an imaging signal received from the electron detection device 240. An imaging signal may correspond to a scanning operation for conducting charged particle imaging. An acquired image may be a single image comprising a plurality of imaging areas. The single image may be stored in the storage. The single image may be an original image that may be divided into a plurality of regions. Each of the regions may comprise one imaging area containing a feature of the sample 208. The acquired images may comprise multiple images of a single imaging area of the sample 208 sampled multiple times over a time period. The multiple images may be stored in the storage. The controller 50 may be configured to perform image processing steps with the multiple images of the same location of the sample 208.

The controller 50 may include measurement circuitry (e.g., analog-to-digital converters) to obtain a distribution of detected charged particles (e.g. signal electrons). The charged particle (e.g. electron) distribution data, collected during a detection time window, can be used in combination with corresponding scan path data of each of the beamlets 211, 212, and 213 incident on the sample surface, to reconstruct images of the sample structures under inspection. The reconstructed images can be used to reveal various features of the internal or external structures of the sample 208. The reconstructed images can thereby be used to reveal any defects that may exist in the sample.

The controller 50 may control the motorized stage 209 to move the sample 208 during inspection of the sample 208. The controller 50 may enable the motorized stage 209 to move the sample 208 in a scan direction, preferably continuously, for example at a constant speed, at least during sample inspection. The controller 50 may control movement of the motorized stage 209 so that it changes the speed of the movement of the sample 208 dependent on various parameters. For example, the controller 50 may control the stage speed (including its direction) depending on the characteristics of the inspection steps of scanning process.

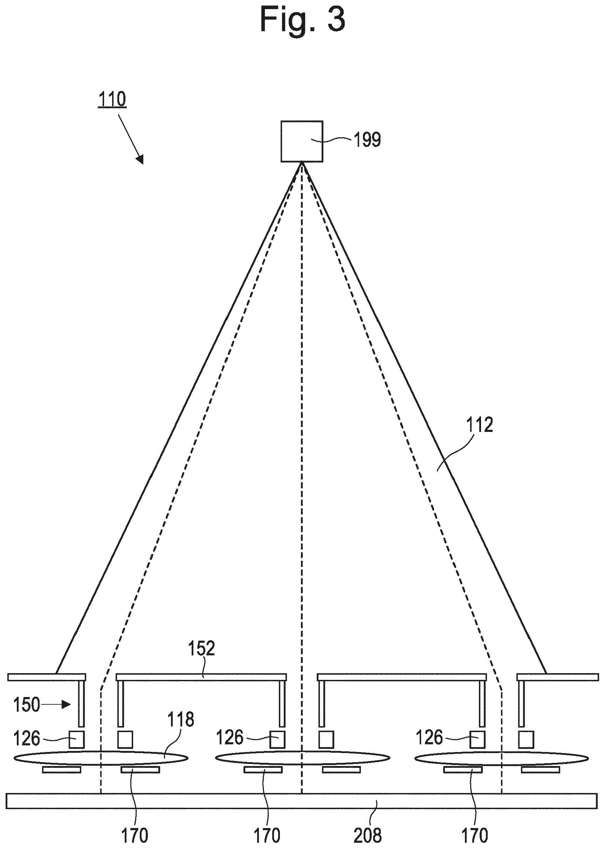

Figure 3 depicts an electron beam column 110. The electron beam column 110 may be provided as part of an electron beam apparatus that projects an electron multi-beam towards a sample 208; for that reason the electron-beam column 110 may be referred to as a multi-electron-beam column 110. The electron beam apparatus may comprise any of the features of the electron beam apparatus 40 discussed above with reference to Figure 2. Associated with each electron beam column 110 is an electron source 199 emitting a beam of electrons 112. (The electron-beam column 110 can be considered also to comprise the electron-beam source 199, but as the source array can be in a separate module from the column, such sources can be separate from the associated column. Such a source may comprise an electron emitter. The source emits an electron beam. The electron-beam column associated with the source operates on, e.g. projects, the electron-beam towards the sample). In some embodiments, charged particles other than electrons are used instead of electrons. The electron source 199 may be configured in any of the ways described above with reference to Figure 2. The electron source 199 may comprise a cathode (not shown) and an extractor or anode (not shown) may be provided. The electron source 199 may comprise a high brightness emitter with a desirable balance between reduced brightness and total emission current. The property reduced brightness takes into account the energy spread of the emitted electrons. In an arrangement there is a plurality of electron sources. The electron source 199 is one source in the plurality of electron sources. The plurality of electron sources form an array of sources and be referred to as a source array. In the source array, the electron sources may be provided on a common substrate.

The electron beam column 110 may comprise a sub-beam defining aperture array 152 (e.g. comprising a plate-like body having a plurality of apertures). The sub-beam defining aperture array 152 forms sub-beams from a beam of electrons 112 emitted by the electron source 199. However, it is not essential for a sub-beam defining aperture array to be provided. In an embodiment the electron beam column 110 is configured to project a single beam towards the sample 208.

In an embodiment the electron beam column 110 comprises a collimator array 150. The collimator array 150 comprises a plurality of collimators. Three collimators are shown in Figure 3. In an alternative embodiment each electron beam column 110 comprises a single collimator of the collimator array 150. The collimator array 150 is down-beam from the sub-beam defining aperture array 152 when the sub-beam defining aperture array 152 is provided. The collimators are each configured to collimate a respective sub-beam. The collimator array 150 forms collimated beamlets from the emitted electrons 112.

The sub-beam defining aperture array 152 may be directly adjacent to the collimator array 150 and/or integrated with the collimator array 150. Each of the collimators in the collimator array 150 may be deflectors and may referred to as collimator deflectors.

The electron beam column 110 further comprises an objective lens array 118 comprising a plurality of objective lenses. Three objective lenses are shown in Figure 3. In an alternative embodiment each electron beam column 110 comprises a single objective lens (which may comprise a plurality of electrodes) of the objective lens array 118. The path of electrons is schematically depicted by broken lines in Figure 3 and it can be seen schematically that the collimators deflect the electrons so that the beamlets are incident substantially normally onto the objective lenses and, thereafter, onto the sample 208. The objective lenses of the objective lens array 118 may be in a common plane. Each objective lens projects a collimated sub-beam onto the sample 208. The distance from the electron source 199 to each objective lens is selected to provide a desired demagnification. The collimation may reduce field curvature effects at the objective lenses, thereby reducing errors caused by field curvature, such as astigmatism and focus error. The collimator array 150 is not provided in an intermediate image plane relative to an array of condenser lenses in the present embodiment. This could increase chromatic aberration and thereby increase a minimum size of illuminated spot on the sample 208. The area illuminated by each electron source 199 may, however, be relatively small so that any increase to the minimum size of illuminated spot due to chromatic aberration may be tolerable.

Objective lens arrays are depicted schematically herein by arrays of oval shapes. Each oval shape represents one of the objective lenses in the objective lens array. The oval shape is used by convention to represent a lens, by analogy to the biconvex form often adopted in optical lenses. In the context of charged particle arrangements such as those discussed herein, it will be understood however that objective lens arrays will typically operate electrostatically and so may not require any physical elements adopting a biconvex shape. The objective lens array may for example comprise at least two plates each with a plurality of holes or apertures. The position of each hole in a plate corresponds to the position of a corresponding hole in another plate. The corresponding holes operate in use on the same sub-beam in the multi-beam.

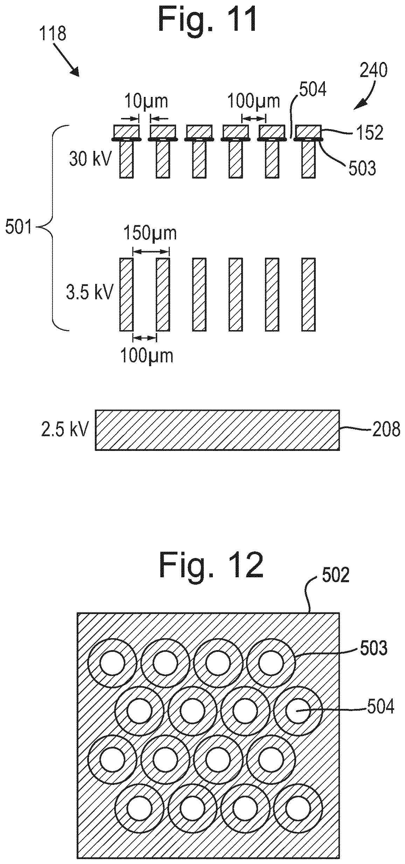

The electron beam column 110 further comprises a detector 170. The detector 170 detects charged particles (e.g. signal electrons) emitted from the sample 208. The detector 170 is provided in a plane down-beam from the sub-beam defining aperture array 152. In some embodiments, as exemplified in Figure 3, the detector 170 is located in a down-beam-most surface of the electron beam column 110 (e.g. facing the sample 208 in use). In other embodiments, as exemplified in Figures 11 and 12 and discussed below, the detector is located in a plane up-beam from the objective lens array 118 or up-beam of at least one electrode of the objective lens array 118. In the example discussed, the detector 170 is located in a down-beam surface of the sub-beam defining aperture array 152.

In an embodiment, the detector 170 comprises a CMOS chip detector integrated with a bottom electrode of one or more of the objective lenses of the objective lens array 118. The detector 170 may be configured in any of the ways described above for the electron detection device 240. The detector 170 may for example generate signals that are sent to a controller 50 or a signal processing system as described above with reference to Figures 1 and 2, e.g. to construct images of areas of the sample 208 scanned over by the multi-beam column 110 or perform other post-processing.

In the embodiment shown, each collimator in the collimator array 150 is directly adjacent to one of the objective lenses in the objective lens array 118. The collimator may be in direct contact with the objective lens or spaced apart from the objective lens by a small distance (with or without any other element being provided in between). By being directly adjacent to an objective lens, the collimator and the sub-beam defining aperture array 152 (which may be the first array element along a beam path from the electron source 199) can be much closer to the sample 208 than in alternative arrangements in which a collimator array is provided further up-beam, for example in an intermediate image plane associated with a condenser lens array. The collimator array 150 and sub-beam defining aperture array 152 are thus closer to the objective lenses and/or the sample 208 than to the electron source 199. A distance between the sub-beam defining aperture array 152 and the objective lenses is desirably much smaller than a distance from the electron source 199 to the sub-beam defining aperture array 152, preferably about 10 times smaller.

Providing the collimator array 150 close to the sample 208 in this manner simplifies the requirements for charged particle optics up-beam of the collimator array 150. The need for correctors to ensure that sub-beams enter the collimators and/or objective lenses with good alignment is less stringent for example (because the sub-beams are formed directly up-beam of the collimators and/or objective lenses, so are intrinsically well aligned).

In some embodiments, as exemplified in Figure 3, the electron beam column 110 is configured so that the electrons propagate from the electron source 199 to the sub-beam defining aperture array 152 without passing through any lens array or deflector array. Avoiding any lens or deflector array element up-beam of the collimator array 150 may mean that a smaller proportion of the electrons from the electron source 199 are guided through the objective lenses but the requirements for electron optics up-beam of the objective lenses, and for correctors to correct for imperfections in such optics, are reduced.

In an alternative embodiment the collimator array 150 is omitted. Omitting the collimator array 150 simplifies the overall arrangement and may allow the sub-beam defining aperture array 152 to be positioned closer to, and/or integrated with, the objective lens array.

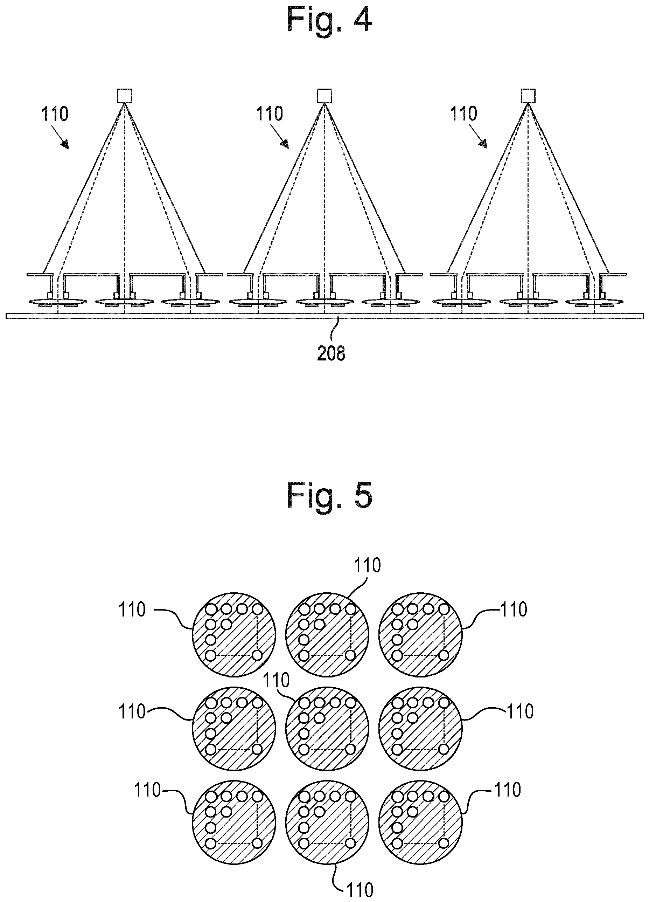

In some embodiments, throughput is increased by using multiple electron sources 199. In some embodiments, as exemplified in Figures 4 and 5, a charged particle multi-beam column array is provided. The charged particle multi-beam column array may comprise a plurality of any of the embodiments of electron beam column 110 described herein. Each electron beam column 110 forms beamlets from electrons emitted by a different respective electron source 199. Each respective electron source 199 may be one source in a plurality of electron sources 199. At least a subset of the plurality of electron sources 199 may be provided as a source array. The source array may comprise a plurality of electron sources 199 provided on a common substrate. The electron beam columns 110 are arranged to project simultaneously onto different regions of the same sample 208. An increased area of the sample 208 can thereby be processed (e.g. assessed) simultaneously. To achieve small spacing between electron beam columns 110, the objective lens array 118 and/or the collimator array 150 of each electron beam column 110 can be manufactured using techniques that are used to manufacture microelectromechanical systems (MEMS) or by using CMOS technology. The electron beam columns 110 may be arranged adjacent to each other so as to project the electron sub-beams onto adjacent regions of the sample 208. Any number of electron beam columns 110 may be used in principle. Preferably, the number of electron beam columns 110 is in the range of from nine to 10,000. In an embodiment, the electron beam columns 110 are arranged in a rectangular array, as depicted schematically in Figure 5. In an alternative embodiment, the electron beam columns 110 are arranged in a hexagonal array. In other embodiments, the electron beam columns 110 are provided in an irregular array or in a regular array having a geometry other than rectangular or hexagonal. Each electron beam column 110 of the multi-beam column array may be configured in any of the ways described herein when referring to a single electron beam column 110.

The sub-beams of each electron beam column 110 can be scanned across a respective individual scanning area of an object plane in which the sample 208 is placed. That is, the sample surface is exposed to the beam spot of each sub-beam. The sample surface exposed by each beam spot may be referred to as a an addressable area. The addressable areas of all sub-beams of a column array can be collectively referred to as the array-addressable area. The array-addressable area is not contiguous because the scanning range of the sub-beams is less than the pitch of the objective lenses 118. A contiguous region of the sample 208 can be scanned by mechanically scanning the sample 208 in the object plane in a scan direction. The mechanical scan of the sample 208 can be a meander or step-and-scan type movement. In an embodiment, the mechanical scan of the sample 208 is a continuous, fixed-speed scan.

An addressable area can be a circular or polygonal region. The region is the smallest such shape that encompasses the addressable area. Regions addressed by adjacent electron beam columns 110 are adjacent on the sample 208 when placed in the object plane. Adjacent regions do not necessarily abut. The electron beam columns 110 may be arranged to cover at least a portion to all of the sample 208. The regions may be spaced apart so that a full portion can be projected onto by the electron beam column 110. The stage may move relative to the electron beam column 110 so that the regions associated with the electron beam columns 110 cover the full portion of the sample 208 without overlap. The footprint of an electron beam column 110 (i.e. the projection of the electron beam column 110 onto the object plane) is typically larger than the region onto which the electron beam column 110 projects sub-beams.

In any of the embodiments described herein, as exemplified in the embodiments of Figures 3 and 4, the electron beam column 110 may comprise one or more aberration correctors 126 configured to reduce one or more aberrations in the sub-beams incident onto the sample 208. Each of at least a subset of the aberration correctors 126 may be integrated with, or directly adjacent to, one or more of the objective lenses in the objective lens array 118 or, where present, one or more of the collimators in the collimator array 150. The aberration correctors 126 may be configured to apply one or more of the following to the sub-beams: focus correction, field curvature correction, astigmatism correction. Corrections may be applied to individual sub-beams (e.g. with each sub-beam potentially receiving a different correction) or to groups of sub-beams (e.g. with the sub-beams within each group all receiving the same correction for at least one type of correction). At least some of the groups may each consist of sub-beams that are all within the same electron beam column 110. Alternatively or additionally, at least some of the groups may each include sub-beams that are in different electron beam columns 110 in a column array. Applying corrections in groups reduces routing requirements for the aberration correctors 126. The aberration correctors 126 may be implemented as described in European patent application number 20168281.2, hereby incorporated by reference, in particular to the disclosure of aperture assemblies and beam manipulator units for applying corrections to sub-beams.

In some embodiments, the column array comprises a focus corrector. The focus corrector may be configured to apply focus corrections to each individual sub-beam. In other embodiments, the focus corrector applies a group focus correction to each of a plurality of groups of sub-beams. Each group focus correction is the same for all of the sub-beams of the respective group. A focus correction can include any or all of corrections in the Z, Rx and Ry directions. As mentioned above, applying corrections in groups may reduce routing requirements. In some embodiments, the focus corrector applies different corrections to sub-beams from different electron beam columns 110. Thus, a focus correction applied to a multi-beam from one electron beam column 110 may be different to a focus correction applied to a multi-beam from a different electron column 110 in the same column array. The focus corrector is thus able to correct for manufacturing or installation differences between different electron beam columns 110 and/or differences in the height of the surface of the sample 208 between different electron beam columns 110. Alternatively or additionally, the focus corrector may apply different corrections to different sub-beams within the same multi-beam. Thus, the focus corrector may be able to provide focus corrections at a finer level of granularity, thereby correcting for example for manufacturing variations within an electron beam column 110 and/or for relatively short-range variations in the height of the surface of the sample 208.

In some embodiments, the focus corrector comprises a mechanical actuator. The mechanical actuator applies each of one or more of the group focus corrections at least partly by mechanical actuation of a focus adjusting element. Mechanical actuation of the focus adjusting element may apply a tilt and/or shift of an entire electron beam column 110 or just part of it, e.g. the objective lens array 118. For example, the focus adjusting element may comprise one or more electrodes of an objective lens array 118 and the mechanical actuator may adjust the focus by moving one or more (e.g. all) electrodes of the objective lens array 118 (e.g. towards or away from the surface of the sample 208). The electrodes may be formed as one or more electrode plates integrated into the objective lens assembly. The electrode plates may be used (e.g. mechanically adjusted) to control the focus of different sub-beams differently.

In some embodiments, one or more scanning deflectors (shown in Figure 9) may be integrated with, or directly adjacent to, one or more of the objective lenses for scanning the beamlets 211, 212, 213 over the sample 208. In an embodiment, the scanning deflectors may be used as described in EP2425444A1 (hereby incorporated by reference in its entirety, and in particular to the disclosure of the use of an aperture array as a scanning deflector).

The aberration correctors 126 may be CMOS based individual programmable deflectors as disclosed in EP2702595A1 or an array of multipole deflectors as disclosed in EP2715768A2, of which the descriptions of the beamlet manipulators in both documents are hereby incorporated by reference.

In an embodiment, the aberration correctors 126 comprise field curvature correctors configured to reduce field curvature. In an embodiment, the field curvature correctors are integrated with, or directly adjacent to, one or more of the objective lenses. In an embodiment, the field curvature correctors comprise passive correctors. Passive correctors could be implemented, for example, by varying the diameter and/or ellipticity of apertures of the objective lenses. The passive correctors may be implemented for example as described in EP2575143A1 hereby incorporated by reference in particular to the disclosed use of aperture patterns to correct astigmatism. The passive nature of passive correctors is desirable because it means that no controlling voltages are required. In embodiments where the passive correctors are implemented by varying the diameter and/or ellipticity of apertures of the objective lenses, the passive correctors provide the further desirable feature of not requiring any additional elements, such as additional lens elements. A challenge with passive correctors is that they are fixed, so the required correction needs to be carefully calculated in advance. Additionally or alternatively, in an embodiment, the field curvature correctors comprise active correctors. The active correctors may controllably correct the path of a charged particle to provide the correction. The active correctors may have: electrodes for a line of charged particle beam paths across the beam array that operate on all sub-beams in the line; an electrode associated with each beam path; or each beam path may have an array of electrodes around the beam path. The electrodes may be individually addressable and may be controlled by way of CMOS circuitry. The correction applied by each active corrector may be controlled by controlling the potential of each of one or more electrodes of the active corrector. In an embodiment, passive correctors apply a coarse correction and active correctors apply a finer and/or tunable correction.

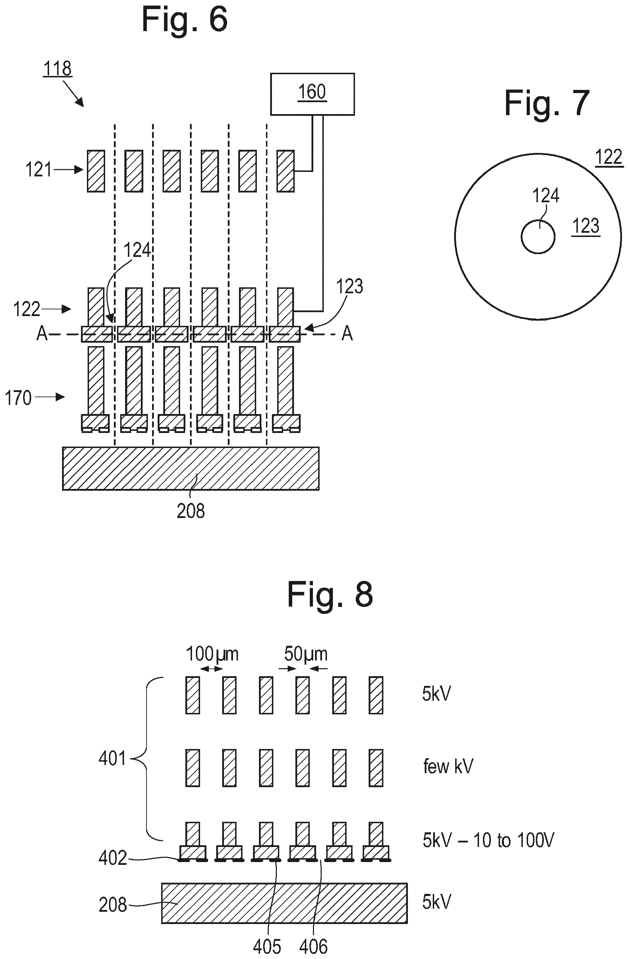

A further embodiment of an objective lens array 118 and a detector 170 is depicted in Figures 6 and 7. This configuration of objective lens array 118 and a detector 170 can be used in combination with any of the multi-beam columns 110 and/or multi-beam column arrays discussed herein. In the arrangement shown, the objective lens array 118 comprises a first electrode 121 and a second electrode 122. The second electrode 122 is between the first electrode 121 and the sample 208. The first electrode 121 and the second electrode 122 may each comprise a conductive body with a plurality of lens apertures that define a corresponding plurality of objective lenses 118. Each objective lens may be defined by a pair of aligned lens apertures, with one of the lens apertures being formed by the first electrode 121 and one of the lens apertures being formed by the second electrode 122. The lens apertures may be circular or non-circular e.g. elliptical. Such shaped apertures may be used for off-axis correction of aberrations in the sub-beams as described in EP Application number 21166214.3 which is hereby incorporated by reference so far as the modifications of the lens apertures for correcting off-axis aberrations.

Each objective lens can be configured to demagnify a sub-beam by a factor greater than 10, desirably in the range of 50 to 100 or more. An electric power source 160 applies a first potential to the first electrode 121. The electric power source 160 applies a second potential to the second electrode 122. In an embodiment, the first and second potentials are such that a sub-beam passing through the objective lens array 118 is decelerated to be incident on the sample 208 with a desired landing energy. The second potential can be similar to the potential of the sample, e.g. about 50 V more positive. Alternatively the second potential can be in the range of from about +500 V to about +1,500 V. The first and/or second potentials can be varied per aperture to effect focus corrections.

To provide the objective lens array 118 with a decelerating function, so that the landing energy can be determined, it is desirable to change the potential of the second electrode and the sample 208. To decelerate electrons the second electrode is made more negative than the first electrode. The highest electrostatic field strength occurs when the lowest landing energy is selected. The distance between the second electrode and first electrode, lowest landing energy and maximum potential difference between second electrode and first electrode are selected so that the resulting field strength is acceptable. For higher landing energies, the electrostatic field becomes lower (less deceleration over the same length).

Because the electron optics configuration between the electron source 199 and the objective lens array 118 remains the same, the beam current remains unchanged with changes in landing energy. Changing the landing energy can affect resolution, either to improve or reduce it.

In some embodiments, as exemplified in Figures 6 and 7, the electron beam column 110 further comprises a down-beam aperture array 123. In the down-beam aperture array 123 is defined a plurality of apertures 124 down-beam from the objective lens array 118. The down-beam aperture array 123 may therefore be down-beam of the objective lens array 118. Each of the apertures 124 is aligned with a corresponding objective lens. Each of the apertures 124 of the down-beam aperture array 123 thus has a corresponding objective lens in the objective lens array 118. The alignment is such that a portion of an electron sub-beam from the objective lens can pass through the aperture 124 and impinge onto the sample 208. Each aperture 124 is furthermore configured to allow only a selected portion (e.g. a central portion) of the electron sub-beam incident onto the down-beam aperture array 123 from the objective lens to pass through the aperture 124. The aperture 124 may for example have a cross-sectional area that is smaller than a cross-sectional area of a corresponding aperture in the sub-beam defining aperture array 152 or of a corresponding sub-beam incident onto the objective lens array 118. The apertures of the down-beam aperture array may thus be of smaller dimension (i.e. smaller area and/or smaller diameter and/or smaller other characteristic dimension) than the corresponding apertures defined in the sub-beam defining aperture array 152 and/or the objective lens array 118.

It is desirable to provide the down-beam aperture array 123 up-beam of the detector 170, as exemplified in Figures 6 and 7. Providing the down-beam aperture array 123 up-beam of the detector 170 ensures that the down-beam aperture array 123 will not obstruct charged particles emitted from the sample 208 and prevent them from reaching the detector 170.

The down-beam aperture array 123 can thus be used to ensure that each electron sub-beam exiting an objective lens of the objective lens array 118 has passed through the center of the respective lens. This can be achieved without requiring a complex alignment procedure to ensure that sub-beams incident onto the objective lenses are well aligned with the objective lenses. Moreover, the effect of the down-beam aperture array 123 will not be disrupted by column alignment actions, source instabilities or mechanical instabilities.

Arrangements comprising a down-beam aperture array 123 configured to operate as described above with reference to Figures 6 and 7 may be used in electron beam columns 110 with a collimator array 150 down-beam from the sub-beam defining aperture array 152 (e.g. as discussed above with reference to Figure 3 for example) and/or in electron beam columns 110 without such a collimator array 150.

In the particular example of Figures 6 and 7, the down-beam aperture array 123 is shown as an element formed separately from a bottom electrode of the objective lens array 118. In other embodiments, the down-beam aperture array 123 may be formed integrally with a bottom electrode of an objective lens array 118 (e.g. by performing lithography to etch away cavities suitable for functioning as lens apertures and beam-blocking apertures on opposite sides of the substrate).

In an embodiment, the apertures 124 in the down-beam aperture array 123 are provided at a distance down-beam from at least a portion of a corresponding lens aperture in a bottom electrode of the corresponding objective lens array 118 by a distance equal to or larger than a diameter of the lens aperture, preferably at least 1.5 times larger than the diameter of the lens aperture, preferably at least 2 times larger than a diameter of the lens aperture.

In the example of Figures 6 and 7, the down-beam aperture array 123 is desirably positioned adjacent to the bottom electrode 122. Where an objective lens array 118 comprises more than two electrodes, such as in an Einzel lens configuration it would be desirable to position the down-beam aperture array 123 adjacent to the middle electrode. The middle electrode has a different potential than the sub-beam energy while the outer electrodes have the same potential as the sub-beam energy. It is generally desirable also to position the down-beam aperture array 123 in a region where the electric field is small, preferably in a substantially field-free region. This avoids or minimizes disruption of a desired lensing effect by the presence of the down-beam aperture array 123.

Figures 8-10 provide further details about how detectors for detecting charged particles emitted by the sample 208 can be configured, referring specifically to the example scenario where the charged particles are electrons. Any of the arrangements discussed below may be used to implement the objective lens array 118 and/or detector 170 in any of the embodiments of electron beam column 110 and/or multi-beam column arrays discussed herein. For example, the detector 170 may be configured in the same way as the detector module 402 and/or 502 referred to below.

As exemplified in Figures 8-10, objective lenses may comprise multi-electrode lenses in which a bottom electrode is integrated with a CMOS chip detector array. The multi-electrode lens may comprise three electrodes, as exemplified in Figure 8, two electrodes, or a different number of electrodes. The arrangement may be described as four or more lens electrodes that are plates. In the plates are defined apertures, for example as aperture arrays, that are aligned with a number of beams in a corresponding beam array. The electrodes may be grouped into two or more electrodes, for example to provide a control electrode group, and an objective electrode group. In an arrangement the objective electrode group has at least three electrodes (shown in Figure 8) and the control electrode group has at least two electrodes (not shown in Figure 8). There may be an electrode which belongs to both groups in which case one surface contributes to one group and the opposing surface contributes to the other group.

Integration of a detector array into the objective lenses replaces the need for a secondary column for detecting the signal electrons. The CMOS chip is preferably orientated to face a sample (because of the small distance (e.g. 100µm) between wafer and bottom of the electron-optical system). In an embodiment, capture electrodes to capture the signal electron are provided. The capture electrodes can be formed in the metal layer of, for example, a CMOS device. The capture electrodes may form the bottom layer of the objective lenses. The capture electrode may form the bottom surface in a CMOS chip. The CMOS chip may be a CMOS chip detector. The CMOS chip may be integrated into the sample facing surface of an objective lens assembly. The capture electrodes are examples of sensor units or detectors for detecting signal electrons. The capture electrodes can be formed in other layers. Power and control signals of the CMOS may be connected to the CMOS by through-silicon vias. For robustness, preferably the bottom electrode consists of two elements: the CMOS chip and a passive Si plate with holes. The plate shields the CMOS from high E-fields.

Sensor units (detectors) associated with a bottom or sample facing surface of an objective lens (objective lens array) are beneficial because the signal electrons may be detected before the electrons encounter and become manipulated by an electron-optical element of the electron-optical system. Beneficially the time taken for detection of such a sample emanating electron may be reduced, preferably minimized.

An exemplary embodiment is shown in Figure 8 which illustrates an objective lens 401 (which may be referred to as an objective lens array) in schematic cross section. On the output side of the objective lens 401, the side facing the sample 208, a detector module 402 is provided. Figure 9 is a bottom view of detector module 402 which comprises a substrate 404 on which are provided a plurality of capture electrodes 405 each surrounding a beam aperture 406. Beam apertures 406 are large enough not to block any of the primary electron sub-beams. Capture electrodes 405 can be considered as examples of sensor units or detectors which signal electrodes and generate a detection signal, in this case an electric current. The beam apertures 406 may be formed by etching through substrate 404. In the arrangement shown in Figure 9, the beam apertures 406 are shown in a rectangular array. The beam apertures 406 can also be differently arranged, e.g., in a hexagonal close packed array.

Figure 10 depicts at a larger scale a part of the detector module 402 in cross section. Capture electrodes 405 form the bottommost, i.e. most close to the sample, surface of the detector module 402. Between the capture electrodes 405 and the main body of the silicon substrate 404 a logic layer 407 is provided. Logic layer 407 may include amplifiers, e.g. Trans Impedance Amplifiers, analogue to digital converters, and readout logic. In an embodiment, there is one amplifier and one analogue to digital converter per capture electrode 405. Logic layer 407 and capture electrodes 405 can be manufactured using a CMOS process with the capture electrodes 405 forming the final metallization layer.

A wiring layer 408 is provided on the backside of substrate 404 and connected to the logic layer 407 by through-silicon vias 409. The number of through-silicon vias 409 need not be the same as the number of beam apertures 406. In particular if the electrode signals are digitized in the logic layer 407 only a small number of through-silicon vias may be required to provide a data bus. Wiring layer 408 can include control lines, data lines and power lines. It will be noted that in spite of the beam apertures 406 there is ample space for all necessary connections. The detection module 402 can also be fabricated using bipolar or other manufacturing techniques. A printed circuit board and/or other semiconductor chips may be provided on the backside of detector module 402.

Figures 11 and 12 exemplify an alternative embodiment in which a detector for detecting charged particles emitted from the sample 208 (an electron detection device 240 in this example) is located in a down-beam surface of a sub-beam defining aperture array 152.

The electron detection device 240 in this example is placed away from the electrode of the objective lens array furthest from the source (i.e. away from a down-beam electrode of the objective lens array). In the example shown, the electron detection device is integrated or associated with an upper electrode of the array of objective lenses 501. The substrate supporting the sensor units 503 during operation may be held at the same potential difference as the upper electrode. In this position, an electrode in the array of objective lenses 501 is closer to the sample than, or down-beam of, the electron detection device 240. Thus, the signal electrons emitted by the sample 208 are accelerated, for example to many kV (perhaps about 28.5kV). As a result the sensor units 503 can comprise, for example, PIN detectors or scintillators. This has the advantage that no significant additional noise sources are present as PIN detectors and scintillators have a large initial amplification of the signal. Another advantage of this arrangement is that it is easier to access the electron detection device 240, e.g. for making power and signal connections or for servicing in use. Sensor units having capture electrodes could be used at this location instead, but this could result in poorer performance. In the embodiment shown in Figure 12, the sensor units 503 are arranged hexagonally only as an example. The sensor units 503 may be arranged in a different way, for example in a rectilinear grid.

A PIN detector comprises a reverse-biased PIN diode and has an intrinsic (very lightly doped) semiconductor region sandwiched between a p-doped and an n-doped region. Signal electrons incident on the intrinsic semiconductor region generate electron-hole pairs and allow a current to flow, generating a detection signal.

A scintillator comprises a material that emits light when electrons are incident on it. A detection signal is generated by imaging the scintillator with a camera or other imaging device.

In an embodiment the sensor unit 503 is configured to simultaneously detect secondary electrons and backscattered electrons, preferably the detectors of the sensor unit face the sample in use . The secondary electrons may be distinguished from the backscattered electrons. For example, in an embodiment the sensor unit 503 may comprise separate regions for the detection of secondary electrons and backscattered electrons. The regions may be separated from each other radially or circumferentially.

The beam apertures 504 associated with the sensor units have smaller diameters than apertures in the objective lens array to increase the surface of the sensor units available to capture electrons emanating from the sample. However, the beam aperture diameters are selected so that they permit passage of the sub-beams; that is the beam apertures 504 are not beam limiting. The beam apertures 504 are designed to permit passage of the sub-beams without shaping their cross-section. The same principle applies to the beam apertures 406 associated with the sensor units 402 of the embodiment described above with reference to Figures 11 and 12.

In another arrangement a detector may be positioned above the objective lens. The detector may comprise sensor units arranged in an array with each sensor unit associated with a sub-beam directed towards the sample. The sensor units may each take the form of an annulus around the path of the corresponding sub-beam. In another arrangement the detector may be up-beam of a Wien filter array to divert signal electrons (from the sample) to corresponding detector elements without influencing the path of the sub-beams directed towards the sample.

In an embodiment, the beam corrector array 145, the beam limiting aperture 133 and/or the deflector array 134 and/or the objective lens array 118 is an exchangeable module, either on its own or in combination with other elements such as arrays. The exchangeable module may be field replaceable, i.e. the module can be swapped for a new module by a field engineer. In an embodiment, multiple exchangeable modules are contained within the tool and can be swapped between operable and non-operable positions without opening the electron beam apparatus 40.

In an embodiment, the exchangeable module is configured to be replaceable within the electron beam apparatus 40. In an embodiment, the exchangeable module is configured to be field replaceable. Field replaceable is intended to mean that the module may be removed and replaced with the same or different module while maintaining the vacuum in which the electron beam apparatus 40 is located. Only a section of the electron beam apparatus 40 is vented corresponding to the module is vented for the module to be removed and returned or replaced.

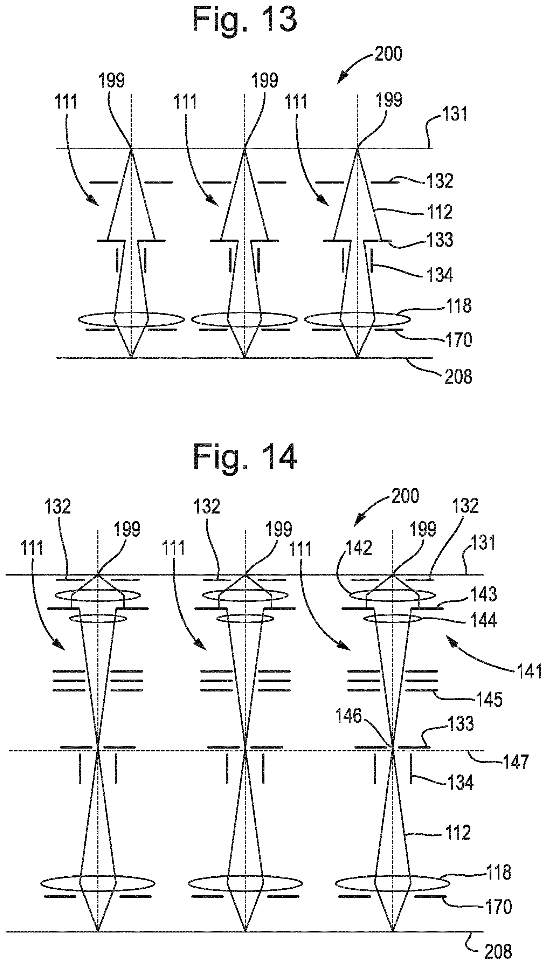

Figure 13 is a schematic diagram of an electron beam apparatus 40 according to an embodiment of the invention. The electron beam apparatus 40 is configured to project electron beams (i.e. beams of electrons 112) towards a sample 208. As shown in Figure 13, in an embodiment the electron beam apparatus 40 comprises a plurality of electron-optical columns 111. The electron-optical columns 111 are configured to project respective electron beams towards the sample 208. In an embodiment the electron-optical columns 111 are comprised in a column array 200. It should be noted that in this arrangement each electron-optical column 111 projects a single beam towards the sample 208. As will be described the beam from the emitter, of a source, through a column is simply shaped.

As shown in Figure 13, in an embodiment each electron-optical column 111 comprises an electron source 199. Alternatively, the electron source 199 may be considered as a separate element from the electron-optical column 111, with the electron source 199 providing electrons for the electron-optical column 111. The electron source 199 is configured to emit the electron beam towards the sample 208. As shown in Figure 13, the electron sources 199 are comprised in a source array 131. In an embodiment the electron sources 199 comprise tips from which the electrons 112 are emitted. Alternatively, the electron sources 199 may not have tips. In an embodiment the electron sources 199 comprise emitters 201 that are semiconductor based. The source array 131 may comprise a semiconductor substrate. The semiconductor substrate may be common to a group of the electron-optical columns 111. In an embodiment the semiconductor substrate of the source array is common to all of the electron-optical columns 111.

In an embodiment the electron source 201 comprises an avalanche diode structure. An avalanche diode structure comprises a stack of doped semiconductor junctions and is biased from two connections. For example, an avalanche diode structure may comprise a PN junction or a PIN junction, An avalanche diode structure may comprise a homo-junction or a hetero-junction having stacks of semiconductors of different band gaps. In an embodiment the avalanche diode structure comprises a hetero-junction of a silicon carbide P-type substrate with a gallium nitride N++ layer on top of it. Gallium nitride has a lower work function (∼1eV lower) and thus more electrons can escape from it. Meanwhile, the silicon carbide has a high thermal conductivity and the ability to make it P-type. The band gap structures influence the electron energy distribution in the avalanching region of the avalanche diode structure. The electron sources 199 may be based on avalanche electron emitting diodes (AEEDs) as emitter technology. AEED emitters are semiconductor based emitters. The AEEDs may alternatively be referred to as avalanche cold cathodes or semiconductor junction cold cathodes. In an embodiment the electron source 201 is junction based. For example, the electron emitter 201 may comprise a diode junction such as a PN junction. In an embodiment the electron source 201 comprises a plurality of junctions. Each junction may be an interface between two layers or regions of similar semiconductors or dissimilar semiconductors. In an embodiment the junction is an interface between doped materials. The junction may be a junction between two or more than two materials. Such a junction may be a diode. In an embodiment the electron source 201 is configured such that an avalanching current is generated inside a diode of the electron emitter 201 that is perpendicular to the surface facing the sample 208. Some electrons 112 are sufficiently energized in the avalanche region to overcome the work function of the surface and be emitted into the vacuum..

An embodiment of the invention is expected to make it easier to manufacture a large number of electron sources 199 in a source array 131 on a substrate. In an embodiment the electron beam apparatus 40 comprises a greater number of electron emitters 201 than sensor units 503 of the detector 170. Such a source array of sources with many emitters per source has a high redundancy rate. In an embodiment the electron emitter 201 is small. In an embodiment the electron emitter has a diameter of at most 2µm, optionally at most 1µm, optionally at most 500nm, optionally at most 200nm, optionally at most 100nm, optionally at most 50nm, optionally at most 20nm, and optionally at most 10nm. In an embodiment the electron emitter has a diameter of at least 5nm, optionally at least 10nm, optionally at least 20nm, optionally at least 50nm, optionally at least 100nm, optionally at least 200nm, optionally at least 500nm, and optionally at least 1µm. Such an emitter may be dimensioned to be around 50 nm and capable of being densely packed. A small emitter results in a smaller virtual source size and an increase in reduced brightness. A small emitter smaller can reduce inter-electron interactions near the surface with drained electrons, thereby reducing the energy spread among emitted electrons. A small emitter can reduce local heat generation and/or increase local power dissipation. The local power dissipation can be higher when the emitter is smaller because the surrounding lattice can drain away the heat better.

In an embodiment, the electron emitters 201 comprise at least one selected from a group consisting of silicon carbide, gallium nitride, aluminium nitride and boron nitride. These materials are semiconductors and have suitably high band gaps. These materials can have high doping levels. In particular, silicon carbide may be preferred because this material also has a high thermal conductivity and has a high electrical breakdown strength. This means that it is possible to apply high fields inside the material to accelerate the electrons. In an embodiment the electron source 199 comprises a corresponding emitter 201 comprising at least one selected from a group consisting of silicon carbide, gallium nitride, aluminium nitride and boron nitride. In an embodiment the silicon carbide, gallium nitride, aluminium nitride or boron nitride forms the surface of the emitter. The electrons are emitted from the surface of the emitter. In an embodiment a combination of two or more of silicon carbide, gallium nitride, aluminium nitride and boron nitride are combined together in the electron source 201. Such materials allow for higher (compared to silicon) avalanche currents at higher breakdown voltage/field.

The materials permit performance at elevated temperatures relative to silicon. In particular these materials are more effective than silicon in keeping the local temperature low because of their higher thermal conductivity. An embodiment of the invention is expected to achieve an improved combination of reduced brightness of the emitter and energy spread of the emitted electrons. In general, when silicon is used for the electron sources 199, there may be a trade-off between reduced brightness and energy spread.

The amount of energy required by the electrons to escape, which may be called the work function, can be controlled by selecting parameters of the electron emitters 201. In general, an increased work function desirably narrows the energy distribution of electrons able to escape and undesirably reduces the vacuum current density and thus reduced brightness. On the other hand, a decreased work function desirably increases the vacuum current density and thus increases reduced brightness but undesirably broadens the energy distribution of electrons able to escape.

Silicon carbide, gallium nitride, aluminium nitride and boron nitride allow for both high reduced brightness and a narrow energy spread simultaneously. In an embodiment the material of the electron emitter 201 has a high thermal conductivity. A higher thermal conductivity can help to provide for a higher local current density and a higher reduced brightness. For example, silicon carbide has a high thermal conductivity. An embodiment of the invention is expected to make it easier to keep the electron sources 199 cool. However, in an alternative embodiment silicon is used instead of any of silicon carbide, gallium nitride, aluminium nitride and boron nitride.

As shown in Figure 13, in an embodiment each electron-optical column 111 is a single beam column. The electron-optical column 111 is configured such that substantially all of the electrons 112 emitted by the electron source 199 associated with the electron-optical column 111 reaching the sample 208 are comprised in a single beam. The electron beam emitted by the electron source 199 reaches the sample 208 without being split or additional beams being generated. Each electron beam corresponds to an electron-optical column 111. This simplifies the electron-optics of each column, for example because off-axis beams are not produced and therefore less collimation and aberration correction is required. The electron-optical column 111 may be called a micro column. In an alternative embodiment, as described above and shown in Figures 2 and 3, the electron beam emitted by the electron source 199 is split into a plurality of beamlets that reach the sample 208.

By having a single beam projected by each column, the beam may follow the electron-optical axis of the column. This is unlike a multi-electron beam column in which all but the central beam is off-axis, resulting in all beams but the central beam having some off-axis aberrations. Such aberrations are typically corrected in the electron-optics, but such corrections introduce additional complexity of the electron-optics for example in requiring additional electron-optical elements and/or modification of existing electron-optical elements to mitigate and/or cancel the aberrations. Otherwise aberrations that are not corrected may reduce throughput.

In an embodiment, the electron-optical columns 111 are manufactured using MEMS technology. An embodiment of the invention is expected to simplify the MEMS-based electron-optical elements of the columns 111. An embodiment of the invention is expected to make it easier to produce MEMS-based electron-optical columns 111. For example, it can be difficult to produce condenser lenses and collimator deflectors for example having correction features and additional correction elements. By providing the electron-optical columns 111 as single beam columns associated with their own electron source 199, it is easier and quicker to align the electron-optical column 111 for example with the source, its emitter and its electron-optical elements with respect to each other and to increase uniformity across the electron-optical columns 111 for example by avoiding the need for additional complexity that having multiple beam paths columns and their related aberration corrections.

As shown in Figure 13, in an embodiment the electron-optical columns 111 comprise a detector 170. The detector 170 may be as described above with reference to Figures 3, 6 and 8-12. Details of the detector 170 are not repeated below so as to be concise, except to note that the detector may be located: under an objective lens array, within the objective lens array, associated with additional electron-optical lensing electrodes associated and adjacently up-beam of the objective lens array and/or up beam of the objective lens array in the column.

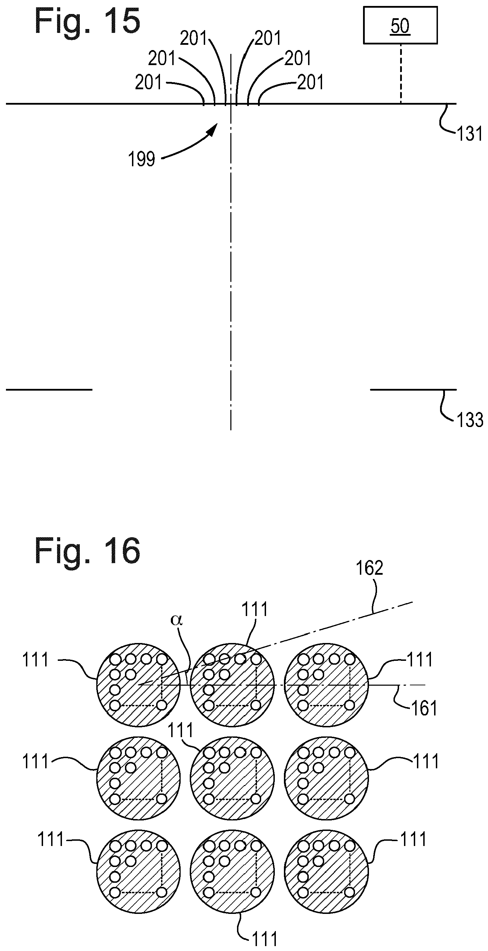

Figure 15 is a schematic diagram showing a plurality of electron emitters 201 for a source 199 of a single electron-optical column 111 with beam limiting aperture 133 . Note that source 199 may include an extractor 132 which is not depicted The electron-optical column 111 may be of the type shown in Figures 13 or 14, for example. Any of the plurality of electron emitters 201 shown in Figure 15 may emit the electron beam for the electron-optical column 111. In an embodiment, at least three, optionally at least nine, optionally at least 16 and optionally at least 100 electron emitters 201 are provided for the electron-optical column 111. In an arrangement a single emitter of the emitter array or emitters 201 is operated to emit an electron beam. As shown in Figure 15, all of the electron emitters 201 are close to the axis of the electron-optical column 111. In Figure 15, the axis is shown as a dot-chain line. The axis corresponds to the line through the centres of the apertures of the electron-optical column 111 through which the electron beam passes.

For example, Figure 15 shows the beam limiting aperture 133 which has an aperture through which the electron beam passes. The aperture of the beam limiting array is configured to define the cross section of the electron beam that is directed onto the sample 208. In an embodiment the beam limiting aperture 133 is configured to select a cross section of the electron beam to be projected towards the sample 208. The beam limiting aperture 133 may be defined in a plate common to a plurality of the electron-optical columns 111. In an embodiment the beam limiting aperture 133 may be defined in a plate common to all of the electron-optical columns 111.

As shown in Figure 15, in an embodiment the distance from the axis to each of the plurality of electron emitters 201 is less than the radius of the electron beam defined by the beam limiting array 133. In an embodiment the distance from the axis to each electron emitter 201 of the electron-optical column 111 is less than 0.1, optionally less than 0.01 and optionally less than 0.001 of the radius of the beam aperture 504. In an embodiment every electron beam is effectively on-axis. In an embodiment, with an emitter dimension of 50 nm, a substantial number can be located within a range of the beam axis of 500nm, for example around one thousand emitters; however, a more practically controllable arrangement would have around ten, fifty or one-hundred emitters. Such an arrangement of an emitter array would enable emitter selection of operation and indicate minimal if any off-axis aberrations in the emitted electron beam. An embodiment of the invention in which the electron-optical columns 111 are single-beam columns is expected to reduce, if not prevent, contributing to off-axis aberrations of the electron beams. An embodiment of the invention is expected to reduce errors in position of the beam spots on the sample 208 formed by the electron beams.

The beam limiting aperture 133 is configured to prevent some electrons 112 from reaching the sample 208. The electrons 112 that are blocked are the electrons 112 that are further from the axis of the electron-optical column 111. In an embodiment the beam limiting aperture 133 is configured to block at least 50% of the electrons 112 that are directed to the beam limiting aperture 133. In an embodiment the beam limiting aperture 133 is configured to block at least 80%, optionally at least 90% and optionally at least 95% of the electrons 112. The beam limiting aperture 133 is arranged such that at most 50%, optionally at most 20%, optionally at most 10% and optionally at most 5% of the electron beam passes down-beam of the beam limiting aperture 133. The proportion of the electron beam that passes down-beam of the beam limiting aperture 133 may be controlled for example by selecting the diameter of the apertures of the beam limiting aperture 133.

An embodiment of the invention is expected to achieve a narrower energy spread of electrons 112 that reach the sample 208. It is possible for different electrons to have different amounts of energy when they reach the sample 208. A narrower range of energies is desirable. The amount of energy that an electron has is at least the amount of energy it is required to have in order to escape to vacuum energy from the electron emitter 201. This amount of energy may be called the escape energy. The escape energy of the electrons is partly dependent on the radial position, i.e. the distance from the centre of the electron beam. The beam limiting aperture 133 is configured such that in general centrally positioned electrons are selected for directing to the sample 208. By only using the centre of the electron beam, the spread of energies among the electrons 112 is reduced. Typically the central portion of the beam, electron energy tends to a common value with little variance. Reducing the size of the central portion may reduce the variance further.

In an embodiment the column array 200 is formed as a stack of semiconductor layers. An embodiment of the invention is expected to make it easier to scale up the number of electron beams projected onto the sample 208. In an embodiment the source array 131 is dimensioned such that the electron sources 199 are each assigned a column. Within the source array, electron emitters 201 extend across a substantial portion of the sample 208. In an embodiment the source array 131 is dimensioned such that the electron sources 199 extend across substantially all of the sample. Thus the emitters 201 extend across substantially all of the sample. In an embodiment the source array 131 is at least as big as the sample 208 that is inspected when viewed along the optical axis. Various different sizes of sample 208 can be inspected. In an embodiment, the sample 208 has a diameter of 300mm, or optionally 450mm. In an embodiment, the source array 131 has a diameter of at least 300mm, or at least 450mm. In an alternative embodiment the source array 131 is smaller than the sample 208. For example, the source array 131 may be dimensioned such that the electron emitters 201 extend across at least 10%, optionally at least 20% and optionally at least 50% of the diameter of the sample 208 (or sample holder 207). In an embodiment the electron emitters201 extend across at least about 30mm perpendicular to the axis. In an embodiment the electron sources 201 extend across at most about 50mm perpendicular to the axis.

An embodiment of the invention is expected to make it easier to provide electron beams scaled to the size of the entire sample 208 or any other arbitrary size and/or shape. In an embodiment the electron sources 199 are arranged in a pattern that matches the shape of the sample 208. For example, the pattern may be roughly circular. The pitch and/or distance between the sources 199 corresponds to the pitch and/or distance between the columns 111. Such a pitch is in the range of 20 to 500 micron, more preferably 30 to 300 micron, or even 50 to 200 micron.

In an embodiment the source array 131 comprises a unitary substrate on which the electron emitters 201 are formed. In an alternative embodiment the source array 131 comprises a plurality of substrates that are positioned adjacent to each other. For example, in an embodiment a plurality of substrates having a dimension of about 100mm in the direction perpendicular to the optical axis are place next to each other above a sample 208 that has a dimension greater than 100mm. An embodiment of the invention is expected to make it easier to inspect a larger proportion of the surface of the sample 208 simultaneously. An embodiment of the invention is expected to increase throughput, i.e. decrease the amount of time required to inspect a sample 208, i.e. the sample surface.

As shown in Figure 13, in an embodiment the electron-optical column 111 comprises an objective lens. The objective lens may comprise at least one electrostatic electrode. In an embodiment the objective lens comprises at least two electrodes, for example as described above with reference to Figure 6. An embodiment the objective lens comprises three electrodes. The objective lens is configured to direct the electron beam towards the sample 208. The objective lenses are comprised in an objective lens array 118. In an embodiment the electrostatic electrode(s) of the objective lens is/are common to a plurality of the electron-optical columns 111. In an embodiment the electrostatic electrode(s) is/are common to all of the electron-optical columns 111.

The detector 170 is configured to detect signal electrons emitted from the sample 208. In an embodiment the detector 170 is associated with the objective lens array 118. The detector 170 may be adjacent to the objective lens array 118 in the beam path of the electrons 112. The detector 170 may be immediately down-beam of the objective lens array 118. In a different embodiment, the detector may be located up-beam of the objective lens array 118. In an embodiment the detector 170 is directly associated with the objective lens array 118. The detector 170 and the objective lens array 118 may be comprised together in a module. In an embodiment the detector 170 and the objective lens array 118 are integrated with each other.

As shown in Figure 13 in an embodiment the source array 131 comprises a plurality of electron sources 199 configured to emit respective electron beams. The column array 200 comprises a plurality of electron-optical columns 111 configured to project a corresponding respective electron beam emitted by an electron source 199 of the source array 131 towards the sample 208.

As shown in Figure 13, in an embodiment the objective lens is the most down-beam element of the electron-optical column 111 configured to affect the electron beam directed towards the sample 208. The objective lens is proximate the sample 208. The detector 170 associated with the objective lens array 118 may be further down-beam than the objective lens. The detector 170 detects signal electrons emitted from the sample 208. The detector 170 is configured such that the electron beam directed towards the sample 208 passes the position of the detector 170 unaffected by the detector 170. The objective lens with electrodes common to the electron-optical columns 111 is proximate the sample 208 along the paths of the electron beams. An embodiment of the invention is expected to reduce the distance between the objective lens and the sample 208. Having the detector proximate to the sample helps reduce cross-talk between signal electrons generated by the beam of column and detectors of other columns.

In an embodiment the electron sources 199 are configured to produce electron beams that are substantially the same as each other. It is possible that there may be some variation between the electron beams generated by the different electron sources 201. In an embodiment the source array 131 comprises a corrector configured to reduce variations between the electron beams. The corrector may be CMOS based. In an embodiment the electron-optics of the electron-optical columns 111 are configured to compensate for variations between the different electron beams.

An embodiment of the invention is expected to reduce the distance between the electron sources 199 and the sample 207. For example, by not requiring the electron beam to be split (or from which to generate sub-beams or beamlets), less space is required to fit the electron-optics between the electron source 199 and the sample 208. The electron source 199 can be placed very close to the sample 208, i.e. closer than otherwise if the column projected a multi-beam and the column generated multiple sub-beams from the beam incidental from the corresponding source. In an embodiment the electron source 199 is configured to produce a lower current of electrons 112 compared to the electron sources that produce electron beams that are split before reaching the sample 208. An embodiment of the invention is expected to reduce the Coulomb interaction within the electron beam. An embodiment of the invention is expected to reduce the voltage to which the electrons 112 are required to be accelerated. For example, in an embodiment the electrons 112 are accelerated to several kV, such as at most about 30kV, optionally at most about 10kV and optionally at most about 5kV. However, in an alternative embodiment the electrons 112 are accelerated to less than 1kV, for example at least about 200V and optionally at least about 500V. In an embodiment, the electrons 112 may have a landing energy of between 100 eV to 10 keV, preferably 300eV to 3keV. An embodiment of the invention is expected to increase design freedom without unduly increasing the risk of electrical breakdown.

As shown in Figure 13, in an embodiment the electron-optical column 111 comprises an extractor 132 which may be referred to as a anode. The extractor 132 is configured to increase emission from the electron source 199. In an embodiment the extractor 132 is between the electron emitter 201 and the sample 208. Alternatively the extractor 132 may be comprised in the electron source 201. In an embodiment the extractor 132comprises an electrode oppositely charged to the charged particles, e.g. electrons. In an embodiment the electrode of the extractor 132 is common to a group of the electron-optical columns 111. In an embodiment the electrode of the extractor 132 is common to all of the electron-optical columns 111. In an embodiment the electrode of the extractor 132 can be controlled simultaneously for a plurality, or all, of the electron-optical columns 111.

As shown in Figure 13, in an embodiment the electron-optical columns 111 comprise deflectors. In an embodiment the deflector is configured to deflect the electron beam in a direction perpendicular to an axis of the electron-optical column 111. The deflectors may be comprised in a deflector array 134 of deflectors for at least a group of the electron-optical columns 111. In an embodiment the deflectors are comprised in a deflector array 134 of deflectors for all of the electron-optical columns 111. The deflectors of the deflector array 134 may be controlled to collimate the beams of the different columns of the multi-columns array, so that the defector array 134 may be referred to a collimator array. For example, the collimator array may collimate the beams so that the beam paths are all substantially parallel towards the sample. The deflector array may be controlled to scan electrostatically the beams across a portion of a sample surface either in one direction, or in two orthogonal directions.

Figure 14 is a schematic view of an alternative column array 200 of electron-optical columns 111. In an embodiment, the electron-optical columns 111 shown in Figure 14 comprise all of the features described above in relation to the arrangement shown in Figure 13. These features are not described again below in order to make this description more concise. As shown in Figure 14, in an embodiment the electron-optical columns 111 comprise a condenser lens arrangement 141 featuring at least one condenser lens. The condenser lens arrangement 141 is between the electron source 199 and the sample 208. In an embodiment the condenser lens arrangement 141 is up-beam of the objective lens array 118. In an embodiment the condenser lens arrangement 141 is up-beam of the deflector array 134. In an embodiment the condenser lens arrangement 141 is up-beam of the beam limiting aperture 133 which may be an aperture plate such as a beam limiting aperture array. It is possible that the beam limiting aperture 133 is replaced by an aperture plate that is not beam limiting. The condenser lens of the condenser lens arrangement 141 is configured to operate on the electron beam.

In an embodiment the condenser lens arrangement 141 comprises a condenser lens electrode. The condenser lens electrode may be a plate electrode of an electrode lens. The condenser electrode may be common to a plurality of the electron-optical columns 111. In an embodiment the condenser lens electrode is common to all of the electron-optical columns 111. In an embodiment the condenser lens arrangement 141 comprises a plurality of condenser lens electrodes such as an up-beam condenser electrode 142 and a down-beam condenser electrode 144. One or more up-beam condenser electrodes 142 may define an up-beam condenser lens; one or more down-beam condenser electrode may defined a down-beam condenser lens. The up-beam condenser electrode 142 and the down-beam condenser electrode 144 may be configured to modify the beam current per electron source. The condenser lens arrangement 141 may comprises a condenser aperture 143 which may be a beam limiting aperture. The condenser aperture 143 may shape the beam, especially in an arrangement in which the beam limiting aperture 133 is absent. The condenser aperture 143 is between the up-beam condenser lens and the down-beam condenser lens. In an embodiment the condenser aperture 143 is comprised in a condenser aperture array for at least a group of the electron-optical columns 111; each aperture of the array operates on the beam of a different column. In an embodiment the condenser aperture 143 is comprised in a condenser aperture array of apertures for all of the electron-optical columns 111. In an embodiment the up-beam condenser electrode 142 is common to at least a group of the electron-optical columns 111. In an embodiment the up-beam condenser electrode 142 is common to all of the electron-optical columns 111. In an embodiment the down-beam condenser electrode 144 is common to at least a group of the electron-optical columns 111. In an embodiment the down-beam condenser electrode 144 is common to all of the electron-optical columns 111. In an alternative embodiment a different arrangement is used for the condenser lens arrangement 141.

As shown in Figure 14, in an embodiment the condenser lens arrangements 141 are configured to focus the electron beam at an intermediate focus 146. The intermediate focus 146 is between the condenser lens 141 and the sample 208. In an embodiment the intermediate focus 146 of a plurality of the electron-optical columns 111 is provided within a common intermediate focus plane 147. The intermediate focus plane may be common to all of the electron-optical columns 111. In an embodiment the intermediate focus 146 is between the beam limiting aperture 133, which may be a plate, and the deflector array 134, so that that beam limiting aperture 133 can shape the beam projected towards the sample. The electron beam may diverge between the intermediate focus 146 and the objective lens array 118. It is not essential for the electron beam to have an intermediate focus 146. In an alternative embodiment, the condenser lens 141 is configured to collimate the electron beam that is directed to the objective lens array 118.

As shown in Figure 14, in an embodiment the electron-optical columns 111 comprise individual beam correctors. The individual beam corrector is configured to correct a property of the electron beam. In an embodiment the individual beam correctors are comprised in a beam corrector array 145 for at least a group of the electron-optical columns 111. The beam corrector array 145 may be configured to provide individual beam correction for the electron beams. The individual beam correction may be a correction of alignment of the electron beam and/or an optimization of the current of the electron beam. In an embodiment the individual beam correctors are comprised in a beam corrector array 145 for all of the electron-optical columns 111. In an embodiment the individual beam corrector is configured to provide a correction for any astigmatism and/or relative beam alignment, for example.

As shown in Figure 14, in an embodiment the individual beam corrector is positioned immediately down-beam of the condenser lens arrangement 141, and in an arrangement is integrated into the condenser lens arrangement 141. As shown in Figure 14, in an embodiment the individual beam corrector is positioned up-beam of the beam limiting aperture 133. In an alternative embodiment, the individual beam corrector is positioned immediately down-beam of the deflector array 134. In another arrangement the individual beam corrector is integrated into the deflector array 134 for example so that the deflector array 134 has the functions of an individual beam corrector and a deflector array 134. These locations are selected because it is beneficial to correct for aberrations as soon as they may have been created in the condenser lens arrangement or close to if not at an intermediate focus where the correction is least likely to induce further aberrations.

As shown in Figure 14, in an embodiment each electron-optical column 111 comprises a plurality of individual beam correctors. The individual beam correctors may be grouped together in the beam path. The individual beam correctors may be for correcting different properties of the electron beam. In an embodiment the individual beam corrector comprises a multipole deflector. The multipole deflector may be manufactured using MEMS technology. In an embodiment the fabrication process is bipolar compatible or uses CMOS technology allowing local electronics to be incorporated, for example enabling sample and hold functionality. The multipole may be a quadrupole having four poles. Alternatively, the multipole may comprise eight or twelve poles, for example, or any reasonable number of poles for example that is a factor of four. In an embodiment the multipole deflector comprises a substantially planar substrate, which is provided with an array of through openings which are regularly arranged in rows and columns. The through openings extend substantially transverse to the surface of the planar substrate and are arranged for passing at least one electron beam through it.

In an embodiment the multipole is associated with a corresponding potential divider. The potential divider is configured to distribute a voltage to the electrodes of the multipole. In an embodiment an electronic control circuit is associated with the multipole deflector. The electronic control circuit may comprise an integrated circuit which has been arranged adjacent to the through openings, in particularly on non-beam areas of the planar substrate. On top of the electronic control circuit, an insulating layer may be provided, on top of which insulating layer, an electrode layer may be arranged. The electronic control circuit is configured to control the electrodes of the multipole deflector, for example, to provide a uniform electric field across the aperture of the multipole around a beam path to operate on that corresponding beam.

Although not shown in Figure 13 or Figure 14, in an embodiment each electron-optical column 111 comprises a control lens array. The control lens array is up-beam of the objective lens array 118. The control lens array is associated with the objective lens array 118. The control lens array is configured to control at least one parameter of the electron beam. For example, the control lens array may be configured to control the landing energy of the electron beam. In an embodiment the control lens array comprises a plurality of control lenses. Each control lens comprises at least two electrodes (e.g. two or three electrodes) connected to respective potential sources.

In an embodiment each electron-optical column 111 comprises a plurality of electron emitters 201. In such an arrangement the source 199 associated with a particular electron-optical column is considered or is even structurally part of that electron-optical column 111, which need not be the case. In an embodiment the electron emitters 201 are configured to be selectable such that a subset of the electron emitters 201 of the electron sources 199 can be selected to emit the electron beams towards the sample 208. By providing that the electron emitters 201 are selectable to provide an electron beam for a source 199 and its associated electron-optical column 111, there is some redundancy in the electron emitters 201. An embodiment of the invention is expected to increase reliability of the electron-optical columns 111 being functional. Due to yield errors there could be underperforming electron emitters 201 in the source array 131. By providing redundancy, the underperforming emitters are less likely to adversely affect the apparatus.

There are different ways in which the electron emitters 201 may be selected. In an embodiment the electron emitters 201 are configured to be selectable by operating (i.e. turning on) a selected electron emitter 201. In an embodiment each electron emitter 201 is configured to be individually controllable to be turned on and off.

In an embodiment the electron emitters are selectable by deflecting the electron beam from a selected emitter towards the beam path in the electron-optical column 111. The selection may be achieved by an arrangement of deflectors (not shown) that are arranged to deflect the beam from the source 199 along the electron-optical axis of the column 111. For example with about ten sources per column, the distance between sources is small so that deflection of the path of the beam is sufficiently small so that introduction of aberrations such as colorimetric aberrations is not significant. In an embodiment the electron-optical sources 209 may comprise deflectors. The deflectors may be in an array, e.g. deflector array. The deflectors may be associated with the emitters. The deflectors are configured to deflect an electron emitted by an emitter so that its path is then a direction along an axis of the electron-optical column 111. The electron beam emitted by the or a selected emitter of a source in the source array may then be directed to the axis of the electron-optical column.

As shown in Figure 5, in an embodiment the electron-optical columns 111 are arranged in a pattern in the column array 200 when viewed along the optical axis. The pattern may be a grid. For example, as shown in Figure 5 the pattern may be a rectilinear grid. In another arrangement the pattern may be hexagonal. The grid may be irregular so that it is skewed, shifted or off-set. Alternatively the pattern may be hexagonal, having alternate rows of electron-optical columns 111 offset by half of the pitch between adjacent electron-optical columns of the same row.

In an embodiment the electron sources 199, or at least their electron beam paths, are arranged in a pattern in the source array 131 when viewed along the optical axis. The pattern may be a grid. For example, the pattern may be a rectilinear or hexagonal grid which may be irregular.. Alternatively such a hexagonal pattern may be regular for example having alternate rows of electron sources 199 offset by half of the pitch between adjacent electron sources 199 of the same row. The electron sources may be arranged in a skewed hexagonal grid. Such a skewed or offset pattern may be desirable because it may assist in ensuring that the path of each beam of the electron-optical columns has a path over a sample partially overlaps with the path of another beam. Yet all paths of the source array may be different. Such an arrangement may be beneficial because it enables redundancy. If a source were to fail, the contribution of the failed source would be taken up by other sources of the source array 131.

In an embodiment the pitch between electron emitters 201 corresponding to the same electron-optical column 111 may be much less than the pitch between electron-optical columns 111 (for example because the position of a group of sources is within a small proportion of the diameter of the derived beam). The electron emitters 201 corresponding to the same electron-optical column 111 may be arranged hexagonally around the beam path. The electron sources 199 may be arranged in a skewed hexagonal grid.

The pattern may comprise a plurality of groups of electron emitters 201, each group corresponding to one of the electron-optical columns 111 and/or a corresponding source 199. In an embodiment a source 199, or a group of electron emitters, comprises at least ten, optionally at least twenty and optionally at least fifty electron emitters 201. In an embodiment a source 199 comprises at most one hundred and fifty, optionally at most one hundred or optionally at most fifty and optionally at least twenty electron emitters 201. In an embodiment, the groups of emitters 201 are spaced apart by regions where there is no electron emitters provided, i.e. a region free of emitters. In an alternative embodiment the electron emitters201 are arranged at regular intervals of the source array 131, such as an emitter 201 or a specified number of emitters are regularly spaced apart over the surface of the source array 131.

Figure 16 is a schematic view along the optical axis of an arrangement of electron-optical columns 111 of a column array 200. In an embodiment the electron beam apparatus 40 is configured such that the sample holder 207 and the electron-optical columns 111 are movable relative to each other in a scanning direction 161. The scanning direction 161 is perpendicular to the optical axis. During use of the electron beam apparatus 40, the sample holder 207 may be moved by operation of the motorized stage 209. Additionally or alternatively, the column array 200 may be mechanically moved in a direction perpendicular to the optical axis. The electron-optical columns 111 are moved relative to the sample 208 along a scanning path. In an embodiment the scanning path comprises straight sections. The scanning path may comprise a meander of straight sections joined by turns. The straight sections may be parallel to each other. The straight sections may be separated from each other by a distance such that all of the surface of the sample 208 is within the field of view of at least one of the electron-optical columns 111 during the scanning process.

Figure 16 schematically shows the pattern in which the electron-optical columns 111 such as those illustrated in Figure 13 or Figure 14, for example, are arranged. As shown in Figure 16, the arrangement may be a rectilinear grid. Alternatively a hexagonal grid arrangement may be used. Such a grid may be irregular such as offset, shifted or skewed. In an embodiment the electron-optical columns 111 are arranged in parallel lines. In Figure 16, three parallel lines are shown, each line comprising three electron-optical columns 111. The number of electron-optical columns 111 in each line may be at least 10, optionally at least 100 and optionally at least 1000. The number of parallel lines may be at least 10, optionally at least 100 and optionally at least 1000.

As shown in Figure 16, in an embodiment the parallel lines are at an oblique angle α to the scanning direction 161. Such an oblique angle in the grid may cause the grid to be irregular. By providing that the parallel lines are at an oblique angle α to the scanning direction 161, redundancy can be introduced into the scanning technique. The oblique angle α corresponds to the array of electron beams formed by the electron-optical columns 111 having an alignment rotation around the vertical axis (i.e. the axis parallel to the direction of the electron beams). The grid in which the electron-optical columns 111 are arranged is skewed with respect to the scanning direction 161. In an embodiment the oblique angle α is at least 1°, optionally at least 2°, optionally at least 5°, optionally at least 10°, and optionally at least 20°. In an embodiment the oblique angle α is at most 20°, optionally at most 10°, optionally at most 5°, optionally at most 2°, and optionally at most 1°. Thus during scanning, the path of the sample under the column array is such that the paths of a beam over the surface the sample align with each other such that a region of the sample surface is scanned. That is the path of a beam on the surface does not overlap the with the path of another beam in the column array. Beam apertures 504 are arranged and aligned relative to the scanning direction 161 so that overlap between beam paths in a scan are reduced or avoided. There may be some (but not complete) overlap between beam paths in a scan.

In an embodiment a method of operating an electron beam apparatus 40 as described above is provided. The method comprises projecting the electron beams emitted by the electron sources 199 towards the sample 208. In an embodiment the method comprises directing the electron beams towards the sample 208 with respective objective lenses. In an embodiment the method comprises detecting signal electrons emitted from the sample 208 with a detector 170 associated with the objective lens array 118. This allows the sample 208 to be inspected. Defects in the sample 208 can be detected based on the detected signal electrons.

In an embodiment the method comprises selecting a subset of electron emitters 201 from, for example a source 199 of, the source array 131 to emit the electron beams. The selection may be made electronically. The method comprises projecting the electron beams emitted by the subset of electron emitters 201 towards the sample 208. In an embodiment the projecting of the electron beams comprises using the electron-optical columns 111 of the column array 200 of electron-optical columns 111.

In an embodiment the method comprises holding the sample 208 with the sample holder 207 and moving the sample holder 207 and the electron-optical columns 111 relative to each other in a scanning direction 161. In an embodiment the electron-optical columns 111 are arranged in parallel lines at an oblique angle α to the scanning direction 161. In an embodiment the sample holder 207 and the electron-optical columns 111 are moved relative to each other such that each electron beam of the electron-optical columns 111 in one of the parallel lines has a different path over the sample 208. In an embodiment the sample holder 207 and the electron-optical columns 111 are moved relative to each other such that each electron beam of the electron-optical columns 111 has a different path over the sample 208 from all other electron beams of the electron-optical columns 111.

In an embodiment a method of scanning a sample 208 comprises using partially overlapping scan regions so that each area is covered by at least one other beam on average. As a result, redundant coverage of the sample 208 allows for defective electron beams to be compensated for. In an embodiment each electron beam has a field of view corresponding to a portion of a surface of the sample 208. The field of view corresponds to the portion that can be reached by the electron beam from the electron-optical column 111. The electron beam can be deflected in the direction perpendicular to the beam path so that the electron beam can reach a portion that extends in the directions perpendicular to the beam path. In an embodiment, when the sample holder 207 and the electron-optical columns 111 move relative to each other the fields of view of adjacent electron beams partially overlap.

In an embodiment the method comprises determining that one or more of the electron beams is defective. Electron beams may be defective due to a manufacturing defect. Electron beams can become defective during use. For example, an electron source 199 that is bombarded with ions may become defective. In an embodiment an ion trap is provided. The ion trap is configured to trap ions that may otherwise adversely affect the electron source 199. The ion trap may comprise an electrode. The ion trap may be integrated with the extractor 132. The ion trap may be made by using planar electron-optics combined with an extraction electrode down-beam of the emitting surface. The planar electron-optics may comprise a semiconductor that is either conductive and/ or resistive. Alternatively, the ion trap may comprise MEMS mirrors, a MEMS based Wien filter or a macro magnetic field generating component.

In an embodiment the method comprises controlling, for example switching off, the electron beams that are determined to be defective. A defective electron beam may be switched off by an electronic control circuit controlling the electron emitter 201 for the defective beam. Emitters may be electronically selected. Alternatively, a defective electron beam can be effectively switched off by controlling the electron-optics of the electron-optical column 111 corresponding to the defective electron beam. Electron beams may be electron-optically selected. For example, the defective electron beam may be deflected such that it cannot reach the sample 208.

Embodiments of the disclosure may be provided in the form of methods, which may use any of the arrangements described above, or other arrangements.

Reference to a component or system of components or elements being controllable to manipulate a charged particle beam in a certain manner includes configuring a controller or control system or control unit to control the component to manipulate the charged particle beam in the manner described, as well optionally using other controllers or devices (e.g. voltage supplies and or current supplies) to control the component to manipulate the charged particle beam in this manner. For example, a voltage supply may be electrically connected to one or more components to apply potentials to the components, such as in a non-limited list the condenser aperture 143, the down-beam condenser electrode 144, the beam corrector array 145, the objective lens array 118, a collimator element array and deflector array 134, under the control of the controller or control system or control unit. An actuatable component, such as a stage, may be controllable to actuate and thus move relative to another components such as the beam path using one or more controllers, control systems, or control units to control the actuation of the component.

The embodiments herein described may take the form of a series of aperture arrays or electron-optical elements arranged in arrays along a beam or a multi-beam path. Such electron-optical elements may be electrostatic. In an embodiment all the electron-optical elements, for example from a beam limiting aperture array to a last electron-optical element in a beam path before a sample, may be electrostatic and/or may be in the form of an aperture array or a plate array. In some arrangements one or more of the electron-optical elements are manufactured as a microelectromechanical system (MEMS) (i.e. using MEMS manufacturing techniques). MEMS are miniaturized mechanical and electromechanical elements that are made using microfabrication techniques. In an embodiment, the exchangeable module mentioned above is a MEMS module. All electron-optical elements, such the array of scanning deflectors unless otherwise explicitly mentioned may be MEMS elements and/or may be made, e.g. formed, using MEMS manufacturing techniques.

Where electrodes are provided that can be set to different potentials relative to each other it will be understood that such electrodes will be electrically isolated from each other. In an embodiment an insulating layer such as an oxide layer or an oxy-nitrate layer is provided to electrically isolate electrodes from each other. If the electrodes are mechanically connected to each other, electrically insulating connectors may be provided. For example, where electrodes are provided as a series of conductive plates that each define an aperture array, for example to form an objective lens array or control lens array, electrically insulating plates may be provided between the conductive plates. The insulating plates may be connected to the conductive plates and thereby act as insulating connectors. The conductive plates may be separated from each other along beam paths by the insulating plates.

References to upper and lower, up and down, above and below should be understood as referring to directions parallel to the (typically but not always vertical) up-beam and down-beam directions of the electron beam or multi-beam impinging on the sample 208. Thus, references to up beam and down beam are intended to refer to directions in respect of the beam path independently of any present gravitational field.

An assessment system according to an embodiment of the disclosure may be a tool which makes a qualitative assessment of a sample (e.g. pass/fail), one which makes a quantitative measurement (e.g. the size of a feature) of a sample or one which generates an image of map of a sample. Examples of assessment systems are inspection tools (e.g. for identifying defects), review tools (e.g. for classifying defects) and metrology tools, or tools capable of performing any combination of assessment functionalities associated with inspection tools, review tools, or metrology tools (e.g. metro-inspection tools). The electron beam apparatus 40 may be a component of an assessment system; such as an inspection tool or a metro-inspection tool, or part of an e-beam lithography tool. Any reference to a tool herein is intended to encompass a device, apparatus or system, the tool comprising various components which may or may not be collocated, and which may even be located in separate rooms, especially for example for data processing elements.

The terms "sub-beam" and "beamlet" are used interchangeably herein and are both understood to encompass any radiation beam derived from a parent radiation beam by dividing or splitting the parent radiation beam. The term "manipulator" is used to encompass any element which affects the path of a sub-beam or beamlet, such as a lens or deflector.

References to elements being aligned along a beam path or sub-beam path are understood to mean that the respective elements are positioned along the beam path or sub-beam path.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims and clauses.

There are provided the following clauses:
Clause 1: A charged particle beam apparatus configured to project charged particle beams towards a sample, wherein the charged particle beam apparatus comprises: a plurality of charged particle-optical columns configured to project respective charged particle beams towards the sample, wherein each charged particle-optical column comprises: a charged particle emitter configured to emit the charged particle beam towards the sample, the charged particle emitters being comprised in a source array; an objective lens comprising an electrostatic electrode configured to direct the charged particle beam towards the sample, the objective lenses being comprised in an objective lens array, the electrostatic electrode being common to a plurality of the charged particle-optical columns; and a detector associated with the objective lens array, configured to detect signal charged particles emitted from the sample, wherein the objective lens is the most down-beam element of the charged particle-optical column configured to affect the charged particle beam directed towards the sample.
Clause 2: A charged particle beam apparatus configured to project charged particle beams towards a sample, wherein the charged particle beam apparatus comprises: a plurality of charged particle-optical columns configured to project respective charged particle beams towards the sample, wherein each charged particle-optical column comprises: a plurality of charged emitters configured to emit the charged particle beam towards the sample, the charged particle emitters being comprised in a source array; and preferably an objective lens configured to direct the charged particle beam towards the sample, the objective lenses being comprised in an objective lens array; wherein the charged particle emitters are configured to be selectable such that a subset of the charged particle emitters can be selected to emit the charged particle beams towards the sample.
Clause 3: A charged particle beam apparatus configured to project charged particle beams towards a sample, wherein the charged particle beam apparatus comprises: a sample holder configured to hold the sample; a plurality of charged particle-optical columns configured to project respective charged particle beams towards the sample, wherein each charged particle-optical column comprises: a plurality of charged particle emitters configured to emit the charged particle beam towards the sample, the charged particle emitters being comprised in a source array; and preferably an objective lens configured to direct the charged particle beam towards the sample, the objective lenses being comprised in an objective lens array; wherein the charged particle beam apparatus is configured such that the sample holder and the charged particle-optical columns are movable relative to each other in a scanning direction, wherein the charged particle-optical columns are arranged in parallel lines at an oblique angle to the scanning direction.
Clause 4: A charged particle beam apparatus configured to project charged particle beams towards a sample, wherein the charged particle beam apparatus comprises:a plurality of charged particle-optical columns configured to project respective charged particle beams towards the sample, wherein each charged particle-optical column comprises: a plurality of charged particle emitters configured to emit the charged particle beam towards the sample, the charged particle sources being comprised in a source array; and preferably an objective lens configured to direct the charged particle beam towards the sample, the objective lenses being comprised in an objective lens array; wherein the charged particle emitters comprise at least one selected from a group consisting of silicon carbide, gallium nitride, aluminium nitride and boron nitride.
Clause 5: The charged particle beam apparatus of any of clauses 1-3, wherein the charged particle emitters comprise at least one selected from a group consisting of silicon carbide, gallium nitride, aluminium nitride and boron nitride.
Clause 6: The charged particle beam apparatus of any of clauses 1, 2 or 4, wherein: the charged particle beam apparatus is configured such that the sample holder and the charged particle-optical columns are movable relative to each other in a scanning direction; and the charged particle-optical columns are arranged in parallel lines at an oblique angle to the scanning direction.
Clause 7: The charged particle beam apparatus of any of clauses 1, 3 or 4, wherein: each charged particle-optical column comprises a plurality of the charged particle emitters; and the charged particle emitters are configured to be selectable such that a subset of the charged particle emitters can be selected to emit the charged particle beams towards the substrate.
Clause 8: The charged particle beam apparatus of any of clauses 2 to 4, wherein: each objective lens comprises an electrostatic electrode, the electrostatic electrode being common to a plurality of the charged particle-optical columns; and each charged particle-optical column comprises a detector associated with the objective lens array, configured to detect signal charged particles emitted from the sample; wherein the objective lens is the most down-beam element of the charged particle-optical column configured to affect the charged particle beam directed towards the sample.
Clause 9: The charged particle beam apparatus of clause 1 or 8, wherein the electrostatic electrode is common to all of the charged particle-optical columns.
Clause 10: The charged particle beam apparatus of clause 3 or 6, wherein each charged particle beam has a field of view corresponding to a portion of a surface of the sample, preferably wherein when the sample holder and the charged particle-optical columns move relative to each other the fields of view of adjacent charged particle beams partially overlap.
Clause 11: The charged particle beam apparatus of any preceding clause, wherein each charged particle-optical column comprises an extractor configured to increase emission from the charged particle emitter.
Clause 12: The charged particle beam apparatus of clause 11, wherein the extractors comprise an extractor electrode common to all of the charged particle-optical columns.
Clause 13: The charged particle beam apparatus of any preceding clause, wherein each charged particle-optical column comprises a beam limiting aperture configured to select a cross section of the charged particle beam to be projected towards the sample, preferably wherein the beam limiting aperture is defined in a plate common to a plurality of the charged particle-optical columns, preferably all of the charged particle-optical columns.
Clause 14: The charged particle beam apparatus of any preceding clause, wherein each charged particle-optical column comprises a deflector configured to deflect the charged particle beam in a direction perpendicular to an axis of the charged particle-optical column, preferably the deflector is comprised in a deflector array of deflectors for at least a group of the charged particle-optical columns.
Clause 15: The charged particle beam apparatus of any preceding clause, wherein each charged particle-optical column comprises a condenser lens configured to operate on the charged particle beam.
Clause 16: The charged particle beam apparatus of clause 15, wherein the condenser lenses comprise at least one condenser electrode common to all of the charged particle-optical columns.
Clause 17: The charged particle beam apparatus of any preceding clause, wherein each charged particle-optical column comprises an individual beam corrector configured to correct a property of the charged particle beam, preferably the corrector is comprised in a beam corrector array for at least a group of the charged particle-optical columns.
Clause 18: The charged particle beam apparatus of any preceding clause, wherein the charged particle emitters are semiconductor based.
Clause 19: The charged particle beam apparatus of any preceding clause, wherein the charged particle emitters comprise avalanche diode structures.
Clause 20: The charged particle beam apparatus of any preceding clause, wherein the source array is dimensioned such that the charged particle emitters extend across a substantial portion of the sample, preferably substantially all of the sample.
Clause 21: The charged particle apparatus of any proceeding clause, wherein the source array comprises a plurality of sources, each source comprising a plurality of the emitters and each source assigned to one of the electron-optical columns.
Clause 22: A method of operating a charged particle beam apparatus comprising: a source array comprising charged particle emitters configured to emit a charged particle beam a plurality in an array of charged particle beams; and an array of charged particle-optical columns comprising a plurality of charged particle-optical columns configured to project respective charged particle beams from the source array towards a sample, wherein the method comprises: projecting the charged particle beams emitted by the charged particle emitters towards the sample; directing the charged particle beams towards the sample with respective objective lenses comprising an electrostatic electrode, the objective lenses being comprised in an objective lens array, by controlling electrostatic electrodes comprising the objective lens array by applying a potential to at least one of the electrodes that is common to a plurality of the charged particle-optical columns; and detect signal charged particles emitted from the sample with a detector associated with the objective lens array, wherein the objective lens is the most down-beam element of the charged particle-optical column configured to affect the charged particle beam directed towards the sample.
Clause 23: A method of operating a charged particle beam apparatus comprising: a source array comprising charged particle emitters configured to emit a charged particle beam a plurality in an array of charged particle beams; and an array of charged particle-optical columns comprising a plurality of charged particle-optical columns configured to project respective charged particle beams from the source array towards a sample, wherein the method comprises: selecting a subset of charged particle emitters from the source array to emit the charged particle beams; and projecting the charged particle beams emitted by the subset of charged particle emitters towards the sample.
T Clause 24: he method of clause 23, wherein the projecting the charged particle beams comprises using the charged particle-optical columns of the array of charged particle-optical columns.
Clause 25: A method of operating a charged particle beam apparatus comprising: a source array comprising: charged particle sources each configured to emit a charged particle beam, the source array configured to emit a plurality of the charged particle beams in an array of charged particle beams; and an array of charged particle-optical columns comprising a plurality of charged particle-optical columns configured to project respective charged particle beams from the source array towards a sample, wherein the method comprises: holding the sample with a sample holder; projecting the charged particle beams emitted by the charged particle sources towards the sample, preferably comprising using the charged particle-optical columns each projecting a single charged particle beam towards the sample; and moving the sample holder and the charged particle-optical columns relative to each other in a scanning direction; wherein the charged particle-optical columns are arranged in parallel lines at an oblique angle to the scanning direction.
Clause 26: The method of clause 25, wherein the sample holder and the charged particle-optical columns are moved relative to each other such that each charged particle beam of the charged particle-optical columns in one of the parallel lines has a different path over the sample.
Clause 27: The method of clause 26, wherein the sample holder and the charged particle-optical columns are moved relative to each other such that each charged particle beam of the charged particle-optical columns has a different path over the sample from all other charged particle beams of the charged particle-optical columns.
Clause 28: A method of operating a charged particle beam apparatus comprising: a source array comprising charged particle sources configured to emit a charged particle beam a plurality in an array of charged particle beams; and an array of charged particle-optical columns comprising a plurality of charged particle-optical columns configured to project respective charged particle beams from the source array towards a sample, wherein the method comprises: projecting the charged particle beams emitted by the charged particle sources towards the sample; wherein the charged particle sources comprise at least one selected from a group consisting of silicon carbide, gallium nitride, aluminium nitride and boron nitride.
Clause 29: A charged particle beam apparatus configured to project charged particle beams towards a sample, wherein the charged particle beam apparatus comprises: a source array comprising a plurality of charged particle sources configured to emit respective charged particle beams; and a charged particle-optical column array comprising a plurality of charged particle-optical columns configured to project a corresponding respective charged particle beam emitted by a charged particle source of the source array towards the sample, wherein each charged particle-optical column comprises: an objective lens and a detector, the objective lens comprising an electrostatic electrode configured to direct the charged particle beam towards the sample, the objective lenses being comprised in an objective lens array, the electrostatic electrode being common to a plurality of the charged particle-optical columns, the detector being associated with the objective lens array and configured to detect signal charged particles emitted from the sample; wherein the objective lens is the most down-beam element of the charged particle-optical column configured to affect the charged particle beam directed towards the sample.
Clause 30: A charged particle beam apparatus configured to project charged particle beams towards a sample, wherein the charged particle beam apparatus comprises: a source array comprising a plurality of charged particle emitters configured to emit respective charged particle beams; a charged particle-optical column array comprising a plurality of charged particle-optical columns configured to project a corresponding respective charged particle beam emitted by a charged particle source of the source array towards the sample, wherein each charged particle-optical column optionally comprises: an objective lens configured to direct the charged particle beam towards the sample, the objective lenses being comprised in an objective lens array; wherein the charged particle emitters are configured to be selectable such that a subset of the charged particle emitters can be selected to emit the charged particle beams towards the substrate.
Clause 31: The charged particle beam apparatus of clause 30, wherein each charged particle source of the subset corresponds to a charged particle-optical column of the charged particle-optical column array.
Clause 32: The charged particle beam apparatus of clause 30 or 31, wherein the number of charged particle sources in the subset is the same as the number of charged particle-optical columns in the charged particle-optical column array.
Clause 33: A charged particle beam apparatus configured to project charged particle beams towards a sample, wherein the charged particle beam apparatus comprises: a sample holder configured to hold the sample; a source array comprising a plurality of charged particle sources configured to emit respective charged particle beams; and a charged particle-optical column array comprising a plurality of charged particle-optical columns configured to project a corresponding respective charged particle beam emitted by a charged particle source of the source array towards the sample, wherein the charged particle beam apparatus is configured such that the sample holder and the charged particle-optical columns are movable relative to each other in a scanning direction, wherein each charged particle-optical column optionally comprises: an objective lens configured to direct the charged particle beam towards the sample, the objective lenses being comprised in an objective lens array; wherein the charged particle-optical columns are arranged in a pattern in which parallel lines of charged particle-optical columns are at an oblique angle to the scanning direction.
Clause 34: A charged particle beam apparatus configured to project charged particle beams towards a sample, wherein the charged particle beam apparatus comprises: a source array comprising a plurality of charged particle sources configured to emit respective charged particle beams; a charged particle-optical column array comprising a plurality of charged particle-optical columns configured to project a corresponding respective charged particle beam emitted by a charged particle source of the source array towards the sample, wherein each charged particle-optical column optionally comprises: an objective lens configured to direct the charged particle beam towards the sample, the objective lenses being comprised in an objective lens array; wherein the charged particle sources comprise at least one selected from a group consisting of silicon carbide, gallium nitride, aluminium nitride and boron nitride..

The descriptions above are intended to be illustrative, not limiting. Thus, it will be apparent to one skilled in the art that modifications may be made as described without departing from the scope of the claims set out below.

## Claims

1. A charged particle beam apparatus configured to project charged particle beams towards a sample, wherein the charged particle beam apparatus comprises:
a plurality of charged particle-optical columns configured to project respective charged particle beams towards the sample, wherein each charged particle-optical column comprises:
a plurality of charged emitters configured to emit the charged particle beam towards the sample, the charged particle emitters being comprised in a source array;
wherein the charged particle emitters are configured to be selectable such that a subset of the charged particle emitters can be selected to emit the charged particle beams towards the sample.

2. The charged particle beam apparatus of claim 1, wherein the emitters are selectable by selectively operating emitters in the source array.

3. The charged particle beam apparatus of claim 1 or 2, wherein the emitters are selectable by deflecting the electron beam from a selected emitter towards the beam path in the electron-optical column.

4. The charged particle beam apparatus of any of claim1 to 3, further comprising a deflector array associated with the charged particle emitters, wherein each deflector of the deflector array is configured to deflect an charged particle emitted by an charged particle emitter in the source array, so that its path of the charged particle is along an axis of the electron-optical column.

5. The charged particle beam apparatus of any preceding claim, wherein each charged particle emitter of the subset corresponds to a charged particle-optical column of the charged particle-optical column array.

6. The charged particle beam apparatus of any preceding claim, wherein the number of charged particle emitters in the subset is the same as the number of charged particle-optical columns in the charged particle-optical column array.

7. The charged particle apparatus of any preceding claim, wherein the source array comprises a plurality of sources, each source comprising the plurality of the emitters and each source assigned to one of the electron-optical columns.

8. The charged particle beam apparatus of any preceding claim, wherein the source array is dimensioned such that the charged particle emitters extend across a substantial portion of the sample, preferably substantially all of the sample.

9. The charged particle beam apparatus of any preceding claim, wherein the charged particle emitters comprise avalanche diode structures.

10. The charged particle beam apparatus of any preceding claim, wherein the charged particle emitters comprise at least one selected from a group consisting of silicon carbide, gallium nitride, aluminium nitride and boron nitride

11. The charged particle beam apparatus of any preceding claim, wherein each charged particle-optical column comprises an extractor configured to increase emission from the charged particle emitter, wherein the extractors comprise an extractor electrode common to all of the charged particle-optical columns.

12. The charged particle beam apparatus of any preceding claim, further comprising an objective lens configured to direct the charged particle beam towards the sample, the objective lenses being comprised in an objective lens array; wherein:
each objective lens comprises an electrostatic electrode, the electrostatic electrode being common to a plurality of the charged particle-optical columns; and
each charged particle-optical column comprises a detector associated with the objective lens array, configured to detect signal charged particles emitted from the sample;
wherein the objective lens is the most down-beam element of the charged particle-optical column configured to affect the charged particle beam directed towards the sample.

13. The charged particle beam apparatus of claim 12, wherein the electrostatic electrode is common to all of the charged particle-optical columns.

14. The charged particle beam apparatus of any preceding claim, wherein each charged particle-optical column comprises an individual beam corrector configured to correct a property of the charged particle beam, preferably the corrector is comprised in a beam corrector array for at least a group of the charged particle-optical columns.

15. The charged particle beam apparatus of any preceding claim, wherein:
the charged particle beam apparatus is configured such that the sample holder and the charged particle-optical columns are movable relative to each other in a scanning direction; and
the charged particle-optical columns are arranged in parallel lines at an oblique angle to the scanning direction.
